# EUROPEAN PATENT APPLICATION

(11) **EP 0 696 108 A1**
(43) Date of publication of application: **07.02.1996**
(21) Application number: 95304953.3
(22) Date of filing: 17.07.1995
(51) Int. Cl.: H03M 13/12, H03M 13/22, G06F 11/10

(54) **Transmission system and apparatus therefor**

(30) Priority: 15.07.1994 JP 163495/94; 23.03.1995 JP 63616/95
(71) Applicant: KABUSHIKI KAISHA TOSHIBA, Kawasaki-shi, Kanagawa-ken 210, Tokyo (JP)
(72) Inventor: Aizawa, Masami, c/o Intell.Property Div., Minato-ku, Tokyo (JP); Okita, Shigeru, c/o Intell.Property Div., Minato-ku, Tokyo (JP)
(74) Representative: Muir, Ian R.

(57) **Abstract**

A transmission system to which an FEC-encoding system is applicable and when the interleave is applied by forming interleave blocks by arranging FEC-encoded symbol sequences according to the FEC-encoding system sequentially in a form of matrix, arranges the symbol sequences obliquely in order for applicable interleave blocks.

## Description

The present invention generally relates to a transmission system and an apparatus to which an interleave system and an error detecting system are applicable in combination with a convolutional or Trellis encoded modulation system.

In general, in transmitting digitized video and audio information, transmission error may be generated as affected by noise and the like which are generated in a transmission line. To restore such information as video and the like which caused this transmission error, an error correcting technique is used.

For instance, the convolutional encoded modulation system or Trellis encoded modulation (hereinafter referred to as TCM) system is generally used for correcting errors caused by random noise. These two encoded modulation systems are somewhat inferior to the Reed-Solomon (hereinafter simply abbreviated to RS) encode in the error characteristic against burst noise. As a countermeasure against the inferior characteristics of these system, an interleave in a unit of the convolutional encoded symbol or the Trellis encoded symbol (hereinafter these units are simply called the encoded symbol units) are used.

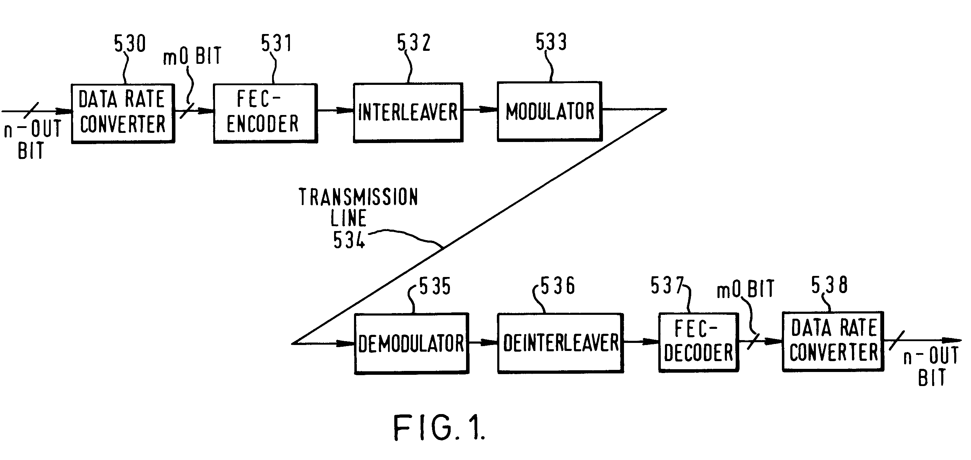

The structure of a conventional receiver-transmitter when such interleave is used will be explained referring to a general block diagram shown in FIGURE 1. As shown in FIGURE 1, the transmission section normally consists of data rate converter 530, FEC-encoder 531, interleaver 532 and modulator 533. The encoded signal output from the transmission section is transmitted to the receiving section through transmission line 534. The receiving section normally consists of demodulator 535, deinterleaver 536. FEC-decoder 537 and data rate converter 538.

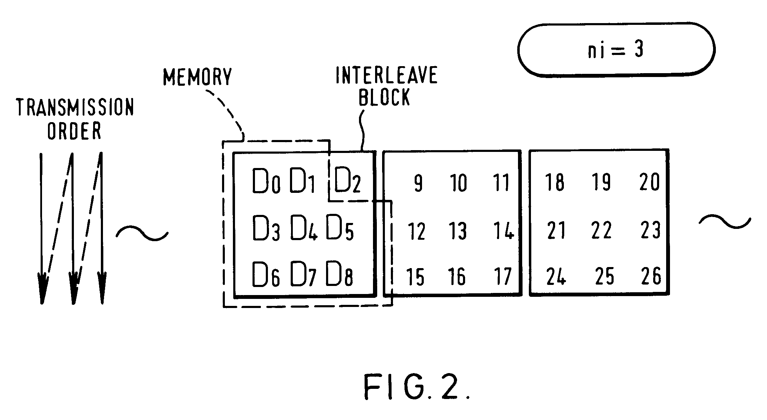

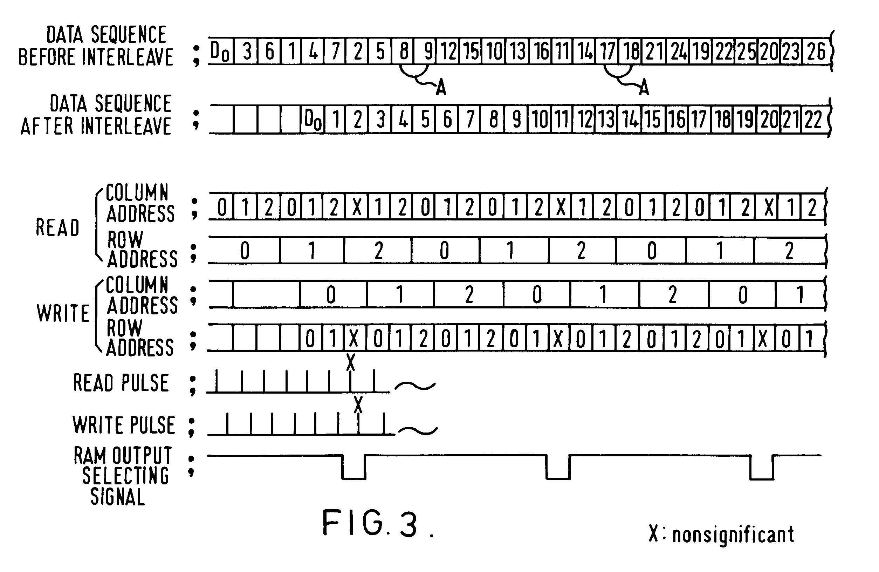

The most general and simple type of interleave system described above is that type shown in FIGURE 2 (Reference Symbol D in the figure has been partially omitted to avoid the drawing complication). In the example shown in FIGURE 2, the interleave is achieved in a unit of interleave blocks of ni rows x ni columns, where the depth of interleave is ni = 3 symbols. Further, the data sequence after the interleave will become as shown in FIGURE 3 and a distance more than ni symbols except the boundary line of the interleave blocks (shown by A in FIGURE 3) can be secured for the adjacent encoded symbols.

Accordingly, the original adjacent encoded symbols are positioned separating a distance of more than ni symbols and the burst error up to ni symbols in the transmission line is random sized after the deinterleave, thus improving the Viterbi decoded or the Trellis decoded error correcting characteristic.

A structural example of the interleaver 532 or the deinterleaver 536 is shown in FIGURE 4. As shown in FIGURE 4, the interleaver 532 and the deinterleaver 538 are constructed by address generator 103a, address selector 103b, RAM 103c and data selector 103d. The circuit shown in FIGURE 4 is to give read address RA and write address WA alternately to a RAM 103c and output data after the interleave or the deinterleave. As shown in FIGURE 5, if the RAM 103c is so controlled that data is written after reading it in one encoded symbol period, a memory needed for the deinterleave will become in the structure as shown in FIGURE 6. Thus, the deinterleave can be achieved with a memory for minimum symbols (ni x ni-1 symbols).

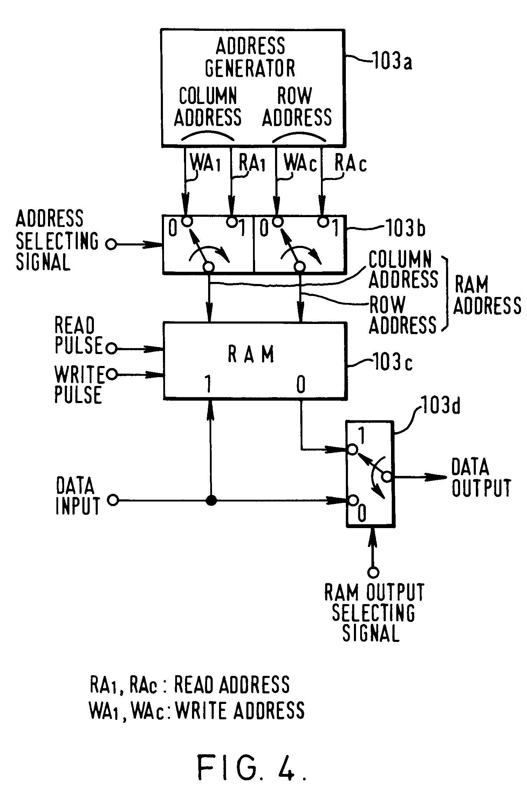

A timing example of the RAM control in the deinterleave is shown in FIGURE 3. For convenience, the RAM addresses are divided into the row addresses and the column addresses corresponding to the rows and columns of an interleave matrix, respectively. In this example, the delay of the deinterleaver is minimized and a RAM output selecting signal becomes "0" for every 9 symbols (= ni x ni symbols) and in FIGURE 4, data input is output directly as data output.

Further, when the deinterleave is performed at the receiving side, it is necessary to decide the interleave block synchronization. This is because the deinterleave will not be carried out properly unless the top position of the interleave blocks is in accord with the top position of the address control for the deinterleave.

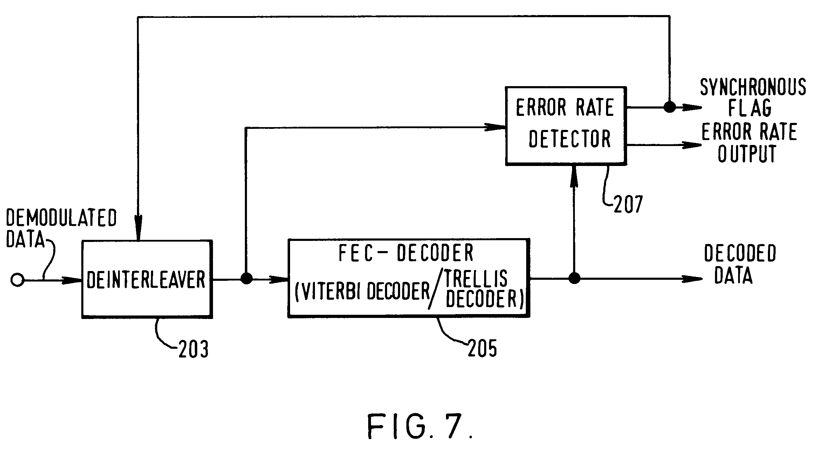

The general structural view for performing this interleave block synchronization is shown in FIGURE 7. As shown in FIGURE 7, the interleave block synchronizer is normally constructed by deinterleaver 203, FEC-decoder 205 and error rate detector 207. In the structure shown in FIGURE 7, an error rate is estimated by correlating data before the FEC-decoding with data sequences after the FEC-decoding in the Forward Error Correction (FEC) system in which the error correction is made at the receiving side using an error correcting encode. In this case, if an error rate exceeds a preestimated value, it is decided that synchronization has stepped out. If C/N (carrier-to-noise ratio) is sufficient, this step-out of synchronization is taken place when the interleave blocks are not synchronized. If the step-out of synchronization is taken place, an error rate is detected and decided again by shifting the address generating timing by one symbol. Repeating this step until an error ratio becomes smaller than the prespecified value, thus achieving the synchronization (the so-called symbol shifting method).

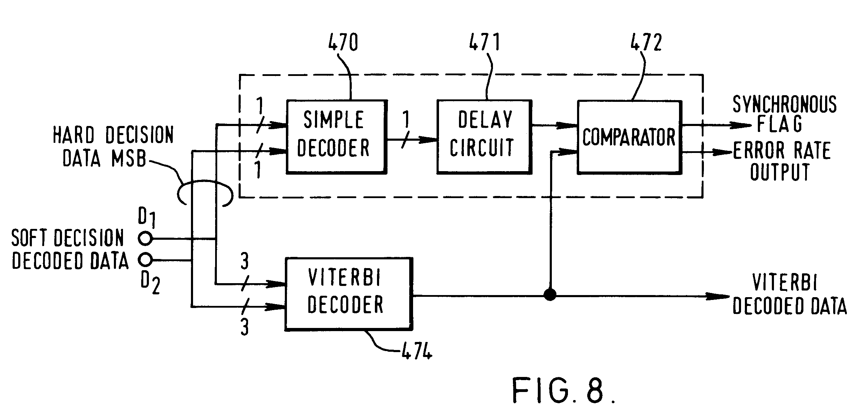

Further, the detection of error rate is achieved through, for instance, the structure shown in FIGURE 8. The structure shown in FIGURE 8 is an example of the convolutional encoding/Viterbi decoding (the encoding rate 1/2), modulation is BPSK signal and the Viterbi decoding is made by 2 symbols of soft decision demodulated data. As shown in FIGURE 8, the convolutional encoder/Viterbi decoder is normally constructed by simple decoder 470, delay circuit 471, comparator 472 and Viterbi decoder 474. The high order 1 bit of this soft decision demodulated data is hard decision data. From this hard decision data 2 bits, the simple decoding is applied (see, for instance, the Japanese Patent Application Tokkai-Hei No. 5-244019) after delayed to fit a time required for the Viterbi decoding. Then, it is compared with the data sequence after the Viterbi decoding. If a C/N is somewhat reasonable at this time, an error rate of the data sequence after the Viterbi decoding is sufficiently smaller than that of the data sequence after the simple decoding and it becomes the error rate of the data sequence itself after the simple decoding. As there is a correlation between the error rate of the data sequence after the simple decoding and that of after the Viterbi decoding, it is possible to estimate the error rate of data sequence after the Viterbi decoding.

However, in case of the interleave system shown in FIGURE 2, adjacent symbols become continuous in the data sequence after the interleave at the boundary line ("A" shown in FIGURE 3) of the interleave blocks and the burst error cannot be random sized.

As compared with the interleave system shown in FIGURE 2, when synchronizing the interleave blocks according to the symbol shift method, 8 times (= (ni x ni - 1) times) of the shift operation and the error rate detection are needed in the worst case and a time is required for the processing. For instance, when ni = 10, 99 times of the shift operation is required in the worst case. In addition, the error rate detection needs a simple decoder 470 as shown in FIGURE 8.

Furthermore, when the convolutional encodes or the Trellis encodes are combined as inner encodes with outer encodes such as RS symbols, etc.. it is required to output data in a unit of one byte after the byte synchronization if, for instance, the number of bits comprising one outer encoded symbol is one byte and therefore, a means for synchronizing bytes was so far required.

It is, therefore, an object of the present invention to provide a transmissin system and an appartus thereof which are capable of providing an interleave system which is excellent in the correction capacity and hardware achievement.

Another object of the present invention is to provide a transmission system and apparatus capable of easily deciding whether such the error as described above is an error resulting from the synchronizing shift in the deinterleave or a transmission error.

For achieving the object described above, the transmission system adaptable for an FEC-encoding system according to the first invention of the present application is characterized in that FEC-encoded symbol sequences are obliquely arranged in order when forming interleave blocks by arranging the FEC-encoded symbol sequences in order into a matrix.

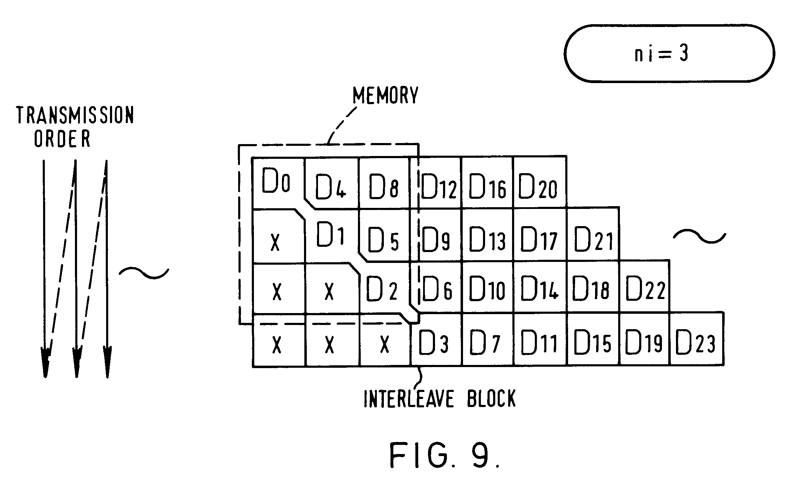

That is, this transmission system achieves the interleave with a distance ni over all data after the interleave by applying the oblique interleave as shown in FIGURE 9 by comprising interleave blocks by dividing input data symbol sequences for every (ni + 1) symbols when the depth of required interleave is ni symbols.

To be concrete, this transmission system is applied with the FEC-encoding according to the convolutional encoding or the Trellis encoding system and it is advisable to comprise interleave blocks by dividing the FEC-encoded (hereinafter referred to as the FEC-encoded symbol sequences) for every (ni + 1) symbols, and comprising an interleave matrix by arranging the interleave blocks obliquely, perform the interleave and send out interleave symbol sequences in the depth of ni symbols at the sending side and perform the FEC-decoding (the Viterbi decoding or Trellis decoding) at the receiving side by performing the operation (I.E., deinterleave operation) of the data sequences corresponding to the interleave symbol sequences reverse to that at the sending side.

The transmission system adaptable for an FEC-encoding system according to the second invention of the present application is characterized in that it comprises a transmitting section in which symbol sequences input in a unit of n-out bits are applied with the rate change from n-out to m0, the FEC-encoded symbol sequence thus obtained are composed to FEC-encoded symbol sequences for every unit of ns symbols, and the interleave symbol sequences are interleaved for transmission, and a receiving section in which a decoded symbol sequences containing m0 bits per symbol are obtained by carrying out a deinterleaving and a FEC-decoding on a received symbol sequence corresponding to the interleaved symbol sequence in opposite to these in the transmitting section, and the FEC-decoded symbol sequences are converted their data rate from m0 to n-out for outputting by a unit of n-out bits wherein the values of I, m0 and n-out are so defined that the product of the I and m0 are divided by the n-out without a reminder.

That is, when sending out the output of the FEC-decoder at the receiving side in a unit of n-out bits after changing the rate, the interleave block length (expressed in the number of bits) is made a common multiple of m0 and n-out if the unit of decoding of FEC-decoded data sequences are m0 bits. This is to select ns x m0 can be divided by n-out if the interleave block length is ns symbols.

To be concrete, this transmission system is applied with an FEC-decoding according to the convolutional or the Trellis encoded modulation system and symbol sequences input in a unit of n-out bits are FEC-encoded for every m0 bits after changing the rate from n-out to m0 and by dividing the FEC-encoded symbol sequences for every ns symbols, interleave blocks are comprised, an interleave matrix is composed in a unit of this interleave block and the interleave symbols are sent out from the sending side while at the receiving side, the FEC-decoded symbol sequences (hereinafter referred to as the FEC-decoded symbol sequences) containing m0 bits per symbol by applying the operation reverse to the sending side, that is, the deinterleave to data sequences corresponding to the interleave symbol sequences to that when the rate is changed from m0 to n-out so that the deinterleaved symbol sequences are output in a unit of n-out bits, ns x m0 is divided by n-out.

A third invention of the present application is characterized in that the interleave block as defined in claim 2 is formed by obliquely arranging the symbol sequence.

The encoder adaptable for an FEC-encoding system according to the fourth invention of the present application is characterized in that it comprises an FEC-encoding means for applying the encoding according to a convolutional encoding modulation system or a Trellis encoding modulation system, and interleave means for composing interleave blocks by sequentially arranging the symbol sequences obtained through the encoding according to the FEC-encoding means.

It is desirable to provide an FEC-encoding device according to the convolutional or Trellis encoded modulation system and an interleave means to comprise an interleave matrix by dividing the FEC-encoded symbol sequences for every FEC-encoded symbol sequences (ni + 1), obliquely arrange the interleave blocks and send out the interleave symbol sequences in the depth of ni symbols.

The transmission system adaptable for an FEC-encoding system according to the fifth invention of the present application is characterized in that it comprises data rate converting means for converting a data rate of symbol sequence input in a unit of n-out bits from the n-out to m0, means for FEC-encoding the symbol sequence output from the data rate converting means for every unit of ns symbols, interleave means for constituting interleaved blocks obtained through the FEC-encoding by dividing the symbol sequence into every unit of ns symbols and then constituting an interleave matrix with I columns by carrying out an oblique arrangement for every interleave block for transmitting the interleaved symbol sequence, and wherein the values of I, m0 and n-out arc so defined that the product of the I and m0 are divided by the n-out without a reminder.

When the transmission system is composed of a rate converter to change the rate of input symbol sequences from n-out to m0, an FEC-encoding device to perform the FEC-encoding for every m0 bits and an interleaver to comprise interleave blocks by dividing the FEC-encoded symbol sequences for every ns symbols and comprising an interleave matrix in a unit of the interleave blocks, send out the interleave symbol sequences, it is desirable to set above encodes so that a product of ns x m0 can be divided by n-out.

A sixth invention of the present application is characterized in that the interleave means as defined in claim 5 carries out the interleave for forming the interleave block by obliquely arranging the symbol sequence.

The decoder in a receiver for decoding FEC-encoded symbol sequence encoded in an FEC-encoding system in obliquely arranged in sequential order according to the seventh invention of the present application is characterized in that it comprises deinterleave means for carrying out a deinterleave for data sequence corresponding to the interleave symbol sequences, means for FEC-decoding the output from the deinterleave means, and error rate detecting means for detecting an error rate of the symbol sequences obtained by the deinterleave means and the FEC-decoding means, and then establishing a synchronous flag corresponding to the detected error rate, and wherein the deinterleaving means establishes synchronization of interleave blocks by shifting the interleave timing when the synchronous flag indicates an asynchronous state.

As to the FEC-encoding system according to the convolutional or Trellis encoded modulation system, in a decoder to receive and decode interleave symbol sequences in the interleaving depth of ni symbols by comprising an interleave matrix by composing interleave blocks by dividing the FEC-encoded symbol sequences (hereinafter referred to as the FEC-encoded symbol sequences) for every (ni + 1) symbols and obliquely arranging the interleave blocks, it is desirable to compose the receiving side provided with a de-interleaving means to apply the deinterleave operation which is reverse to the sending side to data sequences corresponding to the interleave symbol sequences and an error rate detecting means to detect and estimate an error rate in the FEC-decoding, and the error rate detecting means is provided with a function to decide whether an error rate exceeds a prespecified fixed value and output the synchronous flag showing it while if the synchronous flag shows the asynchronous state, the interleaver establishes the synchronization of interleave blocks by shifting the deinterleave timing (the so-called symbol shift method).

The decoder in a receiver for decoding interleaved symbol sequence which is processed a data rate conversion on symbol sequence input in unit of n-out bits from the n-out to m0. FEC-encoding on the symbol sequence obtained by the data rate conversion for every unit of ns symbols, and interleaving for constituting interleaved blocks obtained through the FEC-encoding by dividing the symbol sequence into every unit of ns symbols according to the eighth invention of the present application is characterized in that it comprises deinterleave means for carrying out a deinterleave for data sequence corresponding to the interleave symbol sequences, means for FEC-decoding the output from the deinterleave means, data rate converting means for outputting the output of the FEC-encoding means in a unit of n-out bits after changing the rate from m0 to n-out, and error rate detecting means for detecting an error rate of the symbol sequences obtained by the deinterleave means and the FEC-decoding means, and then establishing a synchronous flag corresponding to the detected error rate, and wherein the deinterleaving means establishes synchronization of interleave blocks by shifting the interleave timing when the synchronous flag indicates an asynchronous state.

A ninth invention of the present application is characterized in that the interleave means as defined in claim 8 carries out a deinterleave on data sequences corresponding to the interleaved symbol sequences constituting the interleave block by obliquely arranging in a sequence order symbol sequences obtained by the FEC-encoding.

A tenth invention of the present application is characterized in that the error rate detecting means as claimed in claim 7 or 8 comprises a convolutional encoder for outputting the whole or part of the convolutionary encoded bits of Viterbi decoded bits obtained through the Viterbi decoding of FEC-decoded symbols, a hard decision circuit for outputting hard decision encoded bits by hard deciding the FEC-decoded symbols, a delay circuit for delaying the hard decision encoded bits by a time required for the Viterbi decoding: and a comparator means for counting the number of disagreed bits between the hard decision encoded bits output from the delay circuit and the encoded bits output from the convolution encoder and estimating and outputting an error rate from the frequency of disagreement.

That is, the tenth invention of this application is characterized in that the whole or part of bits equivalent to the convolutional encoded bits which are the result of hard decision are delayed by a time required for the Viterbi decoding and the result of Viterbi decoding is turned to the restored encoded bits again by convolutionary encoding the same at the sending side and by obtaining frequency of disagreement between the whole or part of them, an error rate of the FEC-decoding is estimated.

Desirably, it is better to comprise the error rate detecting means for detecting and estimating an error rate of the FEC-decoder with a convolution encoder for outputting the whole of part of encoded bits which are decoded and reproduced by convolutionary encoding Viterbi decoded bits out of FEC-decoded symbols, a hard decision circuit for outputting hard decision encoded bits equivalent to the decoded and reproduced encoded bits, a delay circuit for delaying the hard decision encoded bits by a time required for the Viterbi decoding and a comparator means for obtaining frequency of disagreement by counting the number of disagreements between the delay circuit and the decoded and reproduced encoded bits and estimating and outputting the error rate.

The eleventh invention of the present application is characterized in that the comparator means as claimed in claims 10 and 11 determines whether the frequency of disagreements or the estimated error rate exceeds a prespecified threshold value and outputs a synchronous flag showing the synchronous state.

The twelfth invention of the present application is characterized in that the comparator means as claimed in claims 12 and 13 provides two kinds of prespecified thresholds and selects these thresholds properly according to the asynchronous state and the synchronous state.

The thirteenth invention of the present application is characterized in that the FEC-decoding means as claimed in any one of the preceding claims 7, 8, 9, 10, 11 or 12 is provided for an articulated encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

Regarding the FEC-decoder for the articulation-encoding in combination with the convolutlonary encoded modulation or Trellis encoded modulation system as the inner encode and block encodes as the outer encode, it is desirable to comprise the FEC-decoder with an inner FEC-decoder, an error rate detecting means for detecting and estimating an error rate and an outer FEC-decoder, and the outer FEC-decoder performs the vanishing/correction of the synchronous flag of the output from the error rate detecting means as the vanishing flag for the outer block encodes.

Also, a transmission system as claimed in claim 25 of this patent application is characterized in that in a transmission system for information transmission by applying the interleave for every interleave blocks after arranging FEC-encoded symbol sequences according to the FEC-encoding system in a matrix, it is characterized in that the symbol sequences are arranged for every interleave blocks in arbitrarily set arranging order for the interleaving operation.

The transmission system as claimed in claim 26 is characterized in that in a transmission system for information transmission by applying the oblique interleave for every interleave blocks after composing interleave blocks by sequentially arranging FEC-encoded symbol sequences according to the FEC-coding system in an oblique matrix, it is characterized in that the symbol sequences for respective interleave blocks are arranged in arbitrarily set arranging order for composing the oblique interleave blocks.

Further to the transmission system for information transmission as claimed in claim 25 or 26, the transmission system as claimed in claim 27 or 28 is characterized in that the arbitrarily set symbol arranging order is determined by a PN symbol (Pseudo-random number symbol).

Further to the transmission system for information transmission as claimed in one of the claims 25 and 26, the transmission system as claimed in claims 28 and 31 is characterized in that the arbitrarily set symbol arranging order is used for rearranging symbols except the first and the last symbols composing the interleave blocks.

The encoder for interleaving an FEC-encoded symbol sequence for transmission as claimed in claim 33 is characterized in that it comprises an FEC-encoding means for applying the encoding according to a convolutional encoding modulation system or a Trellis encoding modulation system, and means for composing interleave blocks by sequentially arranging the symbol sequences obtained through the encoding according to the FEC-encoding means in a matrix after arbitrarily converting the arranging order.

The encoder for interleaving an FEC-encoded symbol sequence for transmission as claimed in claim 34 is characterized in that it comprises FEC-encoding means for performing the encoding according to a convolutional encoding system or a Trellis encoding modulation system, and means for composing interleave blocks by obliquely arranging the symbol sequences obtained by encoding by the FEC-encoding means after arbitrarily converting the arranging order of symbols for every specified number of symbols.

Further to the encoder as claimed in claim 33 or 34, the encoder as claimed in claim 35 or 36 is characterized in that the symbol arranging order that is arbitrarily convertible is decided by a PN symbol.

Further to the encoder as claimed in claim 33 or 34, the encoder as claimed in claim 37 or 38 is characterized in that the symbol arranging order that is arbitrarily convertible is rearranged excepting the first and the last symbols of the interleave blocks.

The decoder as claimed in claims 39 through 44 for decoding symbol sequence encoded by an encoder as defined by any one of preceding claims 33 through 38 by deinterleaving and decoding the symbol sequences, comprises deinterleave means for deinterleaving the interleaved symbol sequences in the changed sequence, error rate detecting means for detecting an error rate of the symbol sequences obtained by the deinterleave means, and means for supplying the interleaved symbol sequences to the deinterleave means again by sequentially shifting the deinterleave timing by the deinterleave means when the detected error rate exceeds a specified value.

Further to the decoder as claimed in claims 39 through 44, the decoder as claimed in claim B10 is characterized in that the error rate detecting means contains Viterbi decoding means for Viterbi-decoding the deinterleaved symbol sequences, simple decoding means for simply decoding the deinterleaved symbol sequences, and comparator means for detecting an error rate by comparing the decoded result by the Viterbi decoding means with the decoded result by the simple decoding means.

The transmission system for interleaving FEC-encoded symbol sequences for transmission as claimed in claim 51 is characterized in that it comprises a transmitting section in which symbol sequences input in a unit of n-out bits are applied with the rate change from n-out to m0, the FEC-encoded symbol sequence thus obtained are composed to FEC-encoded symbol sequences for every unit of ns symbols, an interleave matrix of the number of rows I is formed by obliquely arranging every interleave blocks, and the interleave symbol sequences are interleaved for transmission, and receiving section in which a decoded symbol sequences containing m0 bits per symbol are obtained by carrying out a deinterleaving and a FEC-decoding on a received symbol sequence corresponding to the interleaved symbol sequence in opposite to those in the transmitting section, and the FEC-decoded symbol sequences are converted their data rate from m0 to n-out for outputting by a unit of n-out bits wherein the values of I, m0 and n-out are so defined that the product of the I and m0 are divided by the n-out without a reminder.

The encoder for interleaving FEC-encoded symbol sequences for transmission as claimed in claim 52 is characterized in that it comprises data rate conversion means for converting the rate of symbol sequences input in a unit of n-out bits from n-out to m0, FEC-encoding means for carrying out the FEC-encoding to the symbol sequences output from the data rate conversion means for every m0 bits, and interleave means for constituting interleaved blocks obtained through the FEC-encoding by dividing the symbol sequence into every unit of ns symbols and then constituting an interleave matrix with I columns by carrying out an oblique arrangement for every interleave block for transmitting the interleaved symbol sequence, and wherein the values of I, m0 and n-out are so defined that the product of the I and m0 are divided by the n-out without a reminder.

The decoder as claimed in claim 53 for decoding an interleaved symbol sequence encoded by the encoder for transmission as defined by claim 62 is characterized in that it comprises deinterleave means for carrying out a deinterleave opposite to those in the transmitting section on the received symbol sequences corresponding to the interleave symbol sequences using an interleave matrix with I columns. FEC-decoding means for carrying out a decoding on the output of the deinterleave means to obtain FEC-decoded symbol sequences containing m0 bits per symbol, and data rate conversion means for converting the data rate of the symbol sequence output from the FEC-decoding means from m0 to n-out to output by a unit of n-out bits, and wherein the values of I, m0 and n-out are so defined that the product of the I and m0 are divided by the n-out without a reminder.

The transmission system for interleaving FEC-encoded symbol sequences for transmission as claimed in claim 54 is characterized in that it comprises a transmitting section in which symbol sequences input in a unit of n-out bits are applied with the rate change from n-out to m0, the FEC-encoded symbol sequence thus obtained are composed to FEC-encoded symbol sequences for every unit of ns symbols, an interleave matrix of the number of rows I is formed by obliquely arranging every interleave blocks in an arbitrarily set arranging order, and the interleave symbol sequences are interleaved for transmission, and a receiving section in which a decoded symbol sequences containing m0 bits per symbol are obtained by carrying out a deinterleaving and a FEC-decoding on a received symbol sequence corresponding to the interleaved symbol sequence in opposite to those in the transmitting section, and the FEC-decoded symbol sequences are converted their data rate from m0 to n-out for outputting by a unit of n-out bits wherein the values of I, m0 and n-out are so defined that the product of the I and m0 are divided by the n-out without a reminder.

The encoder for interleaving FEC-encoded symbol sequences for transmission as claimed in claim 55 is characterized in that it comprises data rate conversion means for converting the rate of symbol sequences input in a unit of n-out bits from n-out to m0, FEC-encoding means for carrying out the FEC-encoding to the symbol sequences output from the data rate conversion means for every m0 bits, and interleave means for constituting interleaved blocks obtained through the FEC-encoding by dividing the symbol sequence into every unit of ns symbols and then constituting an interleave matrix with I columns by carrying out an oblique arrangement through an arbitrarily converting the arrangement order for every interleave block for transmitting the interleaved symbol sequence, and wherein the values of I, m0 and n-out are so defined that the product of the I and m0 are divided by the n-out without a reminder.

The decoder as claimed in claim 56 for decoding an interleaved symbol sequence encoded by the encoder for transmission as defined by claim 55 is characterized in that it comprises deinterleave means for carrying out a deinterleave opposite to those in the transmitting section on the received symbol sequences corresponding to the interleave symbol sequences using an interleave matrix with I columns in the converted order, error rate detecting means for detecting an error rate of the symbol sequences obtained by the deinterleave means, means for supplying the interleaved symbol sequences to the deinterleave means again by sequentially shifting the deinterleave timing by the deinterleave means when the detected error rate exceeds a specified value, FEC-decoding means for carrying out a decoding on the output of the deinterleave means to obtain FEC-decoded symbol sequences containing m0 bits per symbol, and data rate conversion means for converting the data rate of the symbol sequence output from the FEC-decoding means from m0 to n-out to output by a unit of n-out bits, and wherein the values of I, m0 and n-out are so defined that the product of the I and m0 are divided by the n-out without a reminder.

The transmission system of the first invention, the encoder of the fourth invention and the decoder of the seventh invention of this application comprise interleave blocks by arranging FEC-encoded symbol sequences sequentially in a matrix according to the FEC-encoding system and by sequentially arranging the symbol sequences obliquely, it is possible to always secure a distance against the interleave depth ni and at the receiving side, as interleave blocks are (ni + 1), it is possible to synchronize interleave blocks by performing ni times of the shift operation and the error detection in the worst case and achieve the rate reduction to about 1/ni of a conventional system.

The transmission system of the second invention, the encoder of the fifth invention and the decoder of the eighth invention of this application comprise interleave blocks by dividing the symbol sequences obtained by the FEC-encoding for every m0 bits after changing the rate of the symbol sequences which are input in a unit of n-out bits from n-out to m0 and output the interleave symbol sequences at the sending side. At the receiving side, FEC-decoded symbol sequences containing m0 bits per symbol are obtained by applying the deinterleave and FEC-decoding to data sequences corresponding to received interleave symbol sequences and thereafter, the interleaved symbol sequences are output in a unit of n-out bits after changing the rate from m0 to n-out. At this time, if ns, m0 and n-out are so set that a product of ns and m0 can be divided by n-out, the number of bits of FEC-decoded data sequences contained in the interleave block synchronization can be divided by n-out and it becomes possible to divert the rate conversion timing to the rate conversion of the interleave block synchronizing timing.

The transmission system of the third invention, the encoder of the sixth invention and the decoder of the ninth invention of this application comprise interleave blocks and sequentially arrange symbol sequences obliquely to applicable interleave blocks when interleaving them and therefore, it is possible to secure the interleave distance and synchronization establishing rate and also, to divert the rate changing timing to the rate conversion at the timing for synchronizing interleave blocks.

The decoder of the seventh, the eighth, the ninth or the tenth invention of this application is capable of detecting and estimating an error rate without a complicated simple decoding.

The decoder of the eleventh invention of this application is able to decide whether frequency of disagreement or an estimated error rate is in excess of an applicable threshold by providing a prespecified value to the comparator means as a threshold and it becomes possible, for instance, to show the asynchronous state by lowering the synchronous flag if this threshold is exceeded.

The decoder of the twelfth invention of this application is able to provide a hysteresis characteristic to the comparator means by preparing 2 different kinds of thresholds and selecting these thresholds properly according to the asynchronous state and the synchronous state, thus stabilizing the generation of the synchronous flag.

The FEC-decoding means of the decoder of the thirteenth invention of this application performs the vanish correction of the synchronous flag that is output from the error rate detecting means as the vanish flag of the outer block encodes in the outer FEC-decoding. By this vanish correction it is possible to further increase the outer FEC-decoding capacity.

The transmission system as claimed in claim 25 and the encoder as claimed in claim 33 in such the structure as described above make it possible to easily detect the shifted deinterleave starting position which is largely differing from the original proper starting position of the interleave symbol sequences, clearly distinguishing the shifted deinterleave starting position from the transmission line error and providing a large pull in marginal C/N capacity when applying the interleave to the FEC-encoded symbol sequences by arranging them sequentially in a matrix, even if the deinterleave starting position is shifted by one as the interleave is applied in the rearranged sequence.

The transmission system as claimed in claim 26 and the encoder as claimed in claim 34 makes sit possible to attain the rate of about 1/ni by ni times of the shift operation and the error detection in the worst case as the interleave blocks are ni + 1 by sequentially arranging symbol sequences obliquely in a some fixed rearranged sequence when applying the interleave by composing interleave blocks.

The transmission system as claimed in claims 27, 28 and the encoder as claimed in claims 35, 36 make it possible to easily decide a certain fixed rearranged sequence of which timing was so far decided using a ROM, etc. now by a PN symbol (pseudo-random number symbol) using a simple pseudo-random number generator.

The transmission system as claimed in claims 29 through 32 and the encoder as claimed in claims 37, 38 make it possible to minimize the delay in the read and write as the highest and the lowest stage data of the interleave blocks are the same as original data which have not been rearranged.

In the decoder as claimed in claims 39 through 44, data that are encoded by the encoder claimed in claims 33 through 38 are decoded and if an error rate is large, it is decided that the deinterleave starting position has been shifted and the deinterleave is carried out while the starting position is shifted by one at a time. It is therefore possible to accurately adjust the deinterleave starting position.

In the decoder as claimed in claims 46 through 50, the error detecting means claimed in claims 39 through 44 Viterbi decodes the deinterleaved data on the one hand and simply decodes them on the other hand. And assuming that the result of Viterbi decoded are proper data, an error rate is detected by comparing the Viterbi decoding result with the simple decoding result.

According to the transmission system, the encoder and the decoder as claimed in claims 51 through 56, at the transmitting section, symbol sequences that are input in a unit of n-out bits are FEC-encoded for every m0 bits after the rate conversion from n-out to m0, and by forming interleave blocks by dividing the FEC-encoded symbol sequences for every ns symbols, interleaved by forming an interleave matrix of the number of rows I and the values of I, m0 and n-out are so set that a product of I and m0 becomes divisible by n-out, while at the receiving section, it becomes possible to attain the bit synchronization without use of a synchronous symbol even when the top positions of ns size interleave blocks are not in accord with each other and are shifted in the column direction.

Additional objects and advantages of the present invention will be apparent to persons skilled in the art from a study of the following description and the accompanying drawings, which are hereby incorporated in and constitute a part of this specification.

For a better understandings of the present invention and many of the attendant advantages thereof, reference will now be made by way of example to the accompanying drawings, wherein:
FIGURE 1 is a block diagram showing the outline of the structures of a receiver-transmitter when the interleave is used;
FIGURE 2 is a drawing showing the structural example and sending sequence of conventional interleave blocks;
FIGURE 3 is atiming chart showing the deinterleave timing of the interleave blocks shown in FIGURE 2;
FIGURE 4 is a block diagram showing a structural example of a conventional interleave/deinterleaver;

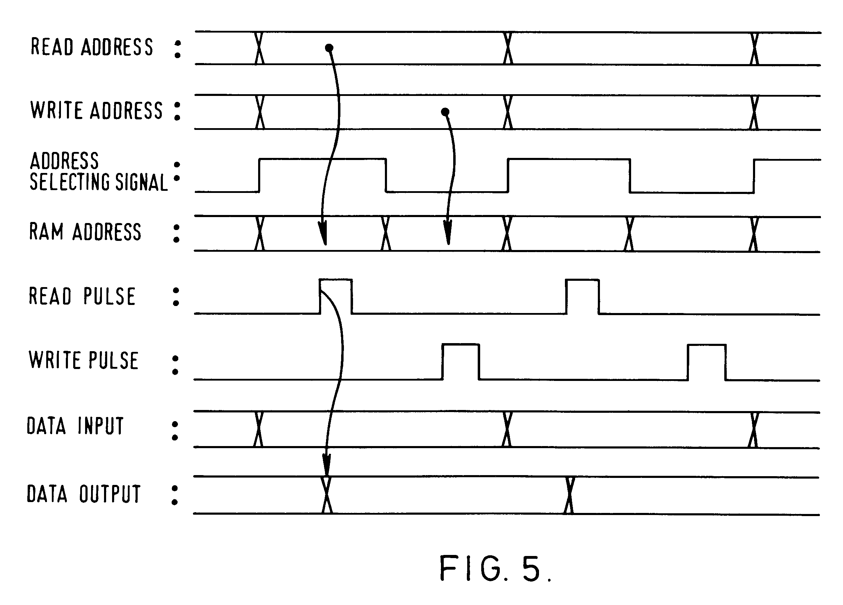

FIGURE 5 is a timing chart showing the timing in the interleave/deinterleaver shown in FIGURE 4;

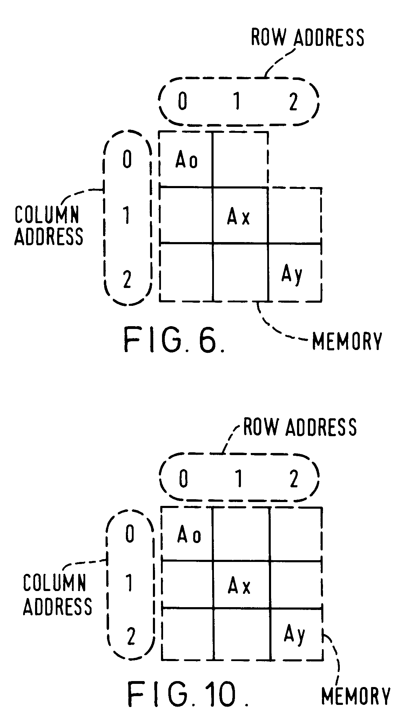

FIGURE 6 is a drawing showing an example of the interleave block memory structure and addresses shown in FIGURE 2;
FIGURE 7 is a block diagram showing a structural example of a conventional deinterleaver and an error rate detector;
FIGURE 8 is a block diagram showing a structural example of a conventional error rate detector;
FIGURE 9 is a drawing showing a structural example of an interleave blocks of the present invention;

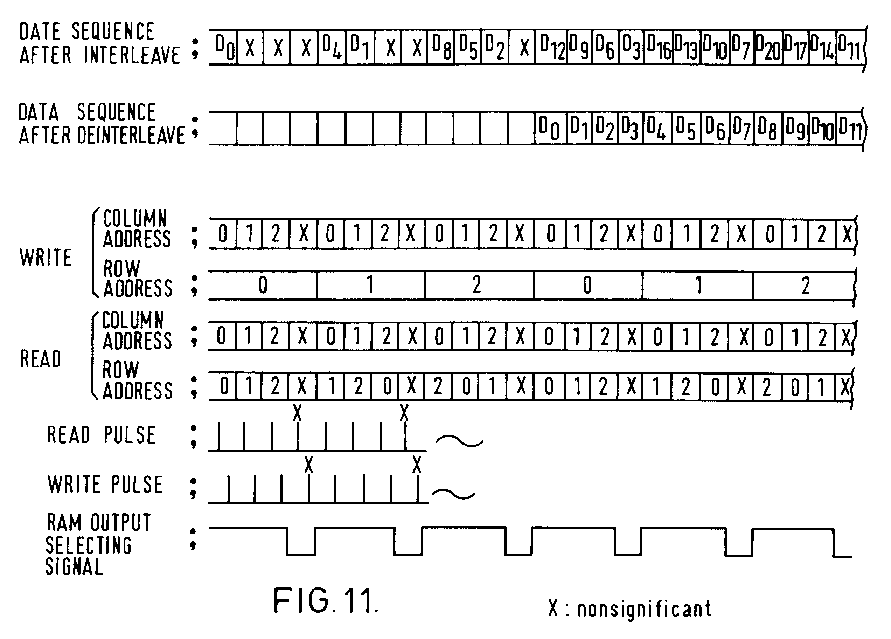

FIGURE 10 is a drawing showing an example of addresses of the interleave blocks shown in FIGURE 9;
FIGURE 11 is a timing chart of the deinterleave timing relative to the interleave blocks shown in FIGURE 9;

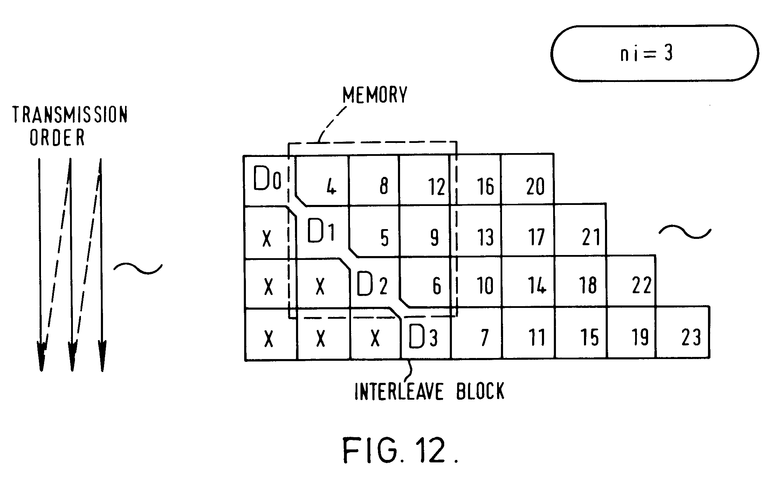

FIGURE 12 is a drawing showing the relation between the interleave block memory and data which are shifted by one column;

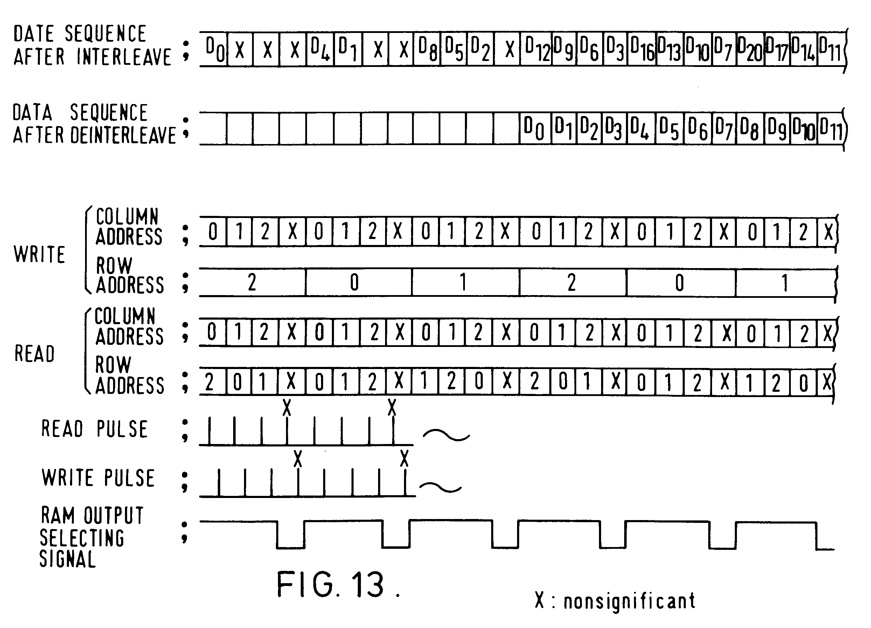

FIGURE 13 is a timing chart showing the deinterleave address generating timing relative to the interleave blocks shown in FIGURE 12;

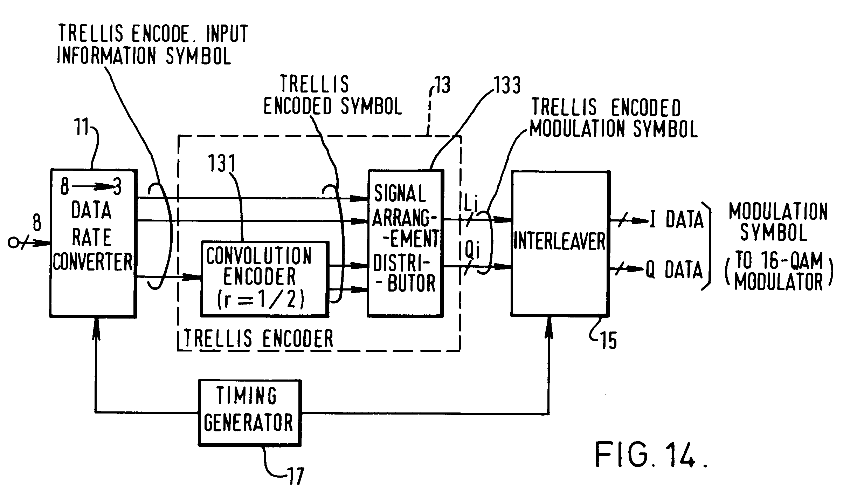

FIGURE 14 is a block diagram showing the structure of an embodiment including an inner FEC-encoder of the present invention;

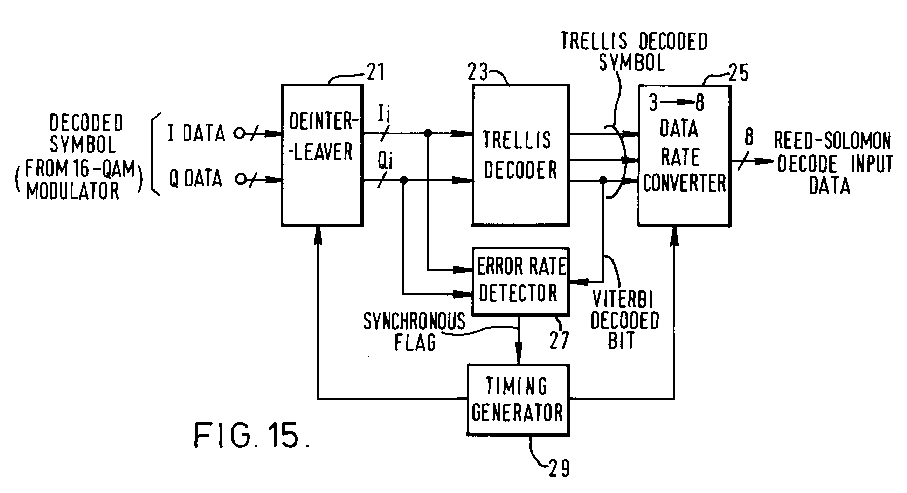

FIGURE 15 is a block diagram showing the structure of an embodiment including an inner FEC-encoder of the present invention;

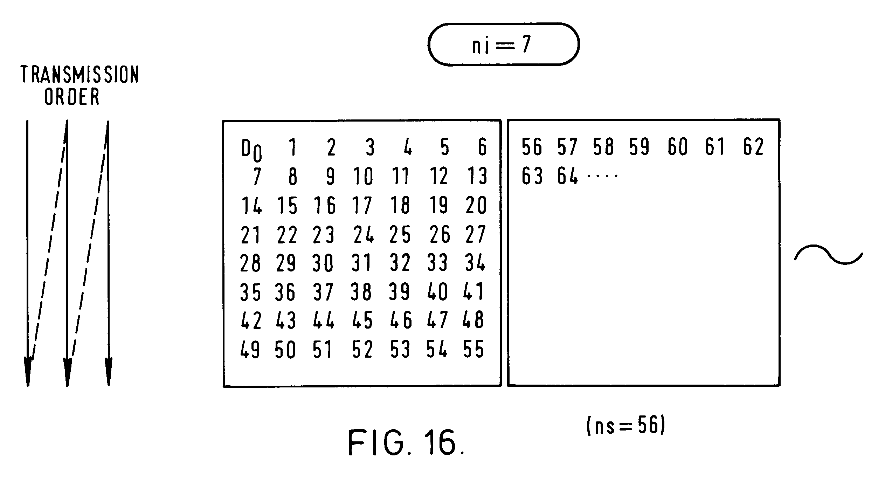

FIGURE 16 is a drawing showing the structural example of an embodiment of interleave blocks that are usable for synchronization of bytes of the present invention;

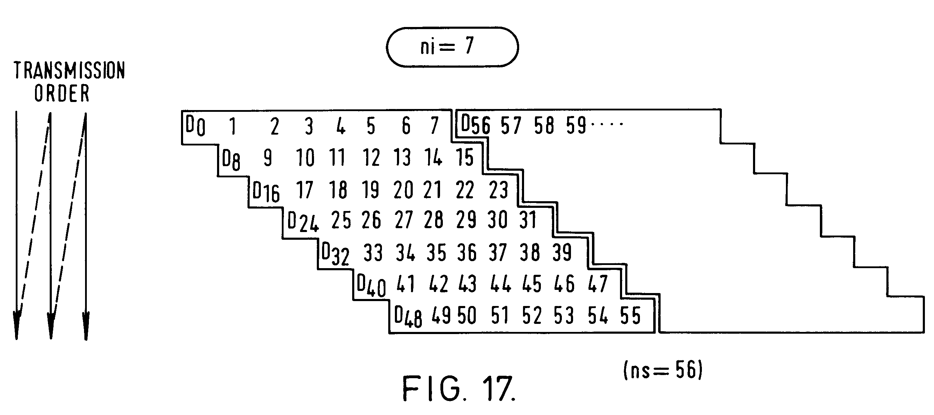

FIGURE 17 is a drawing showing the structural example of an embodiment of interleave blocks that are usable for synchronlzation of bytes of the present invention;

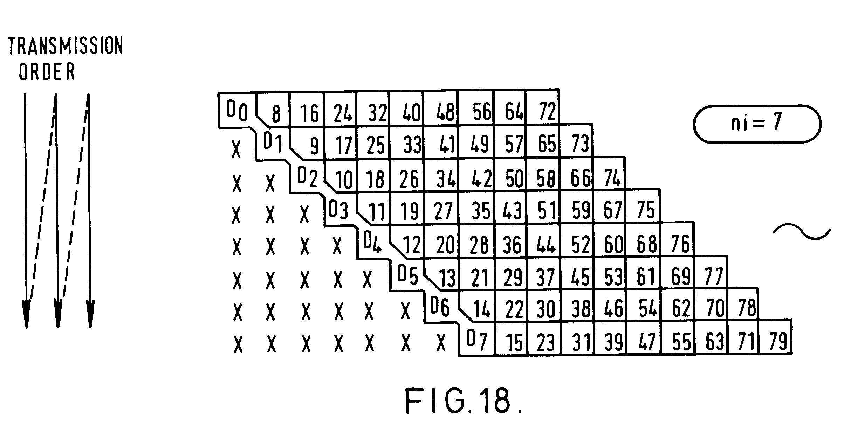

FIGURE 18 is a drawing showing the structural example of an embodiment of interleave blocks that are usable for synchronization of bytes of the present invention;

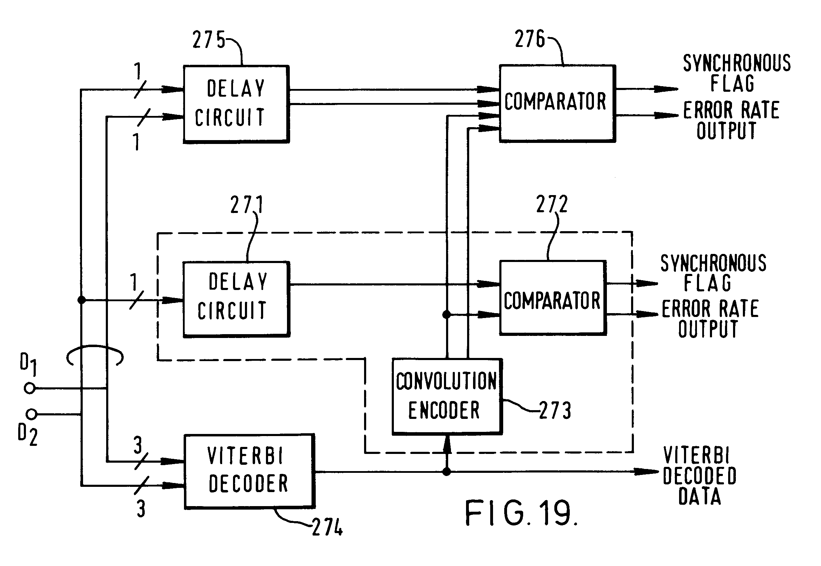

FIGURE 19 is a block diagram showing an example of the structure of an error rate detector of the present invention;

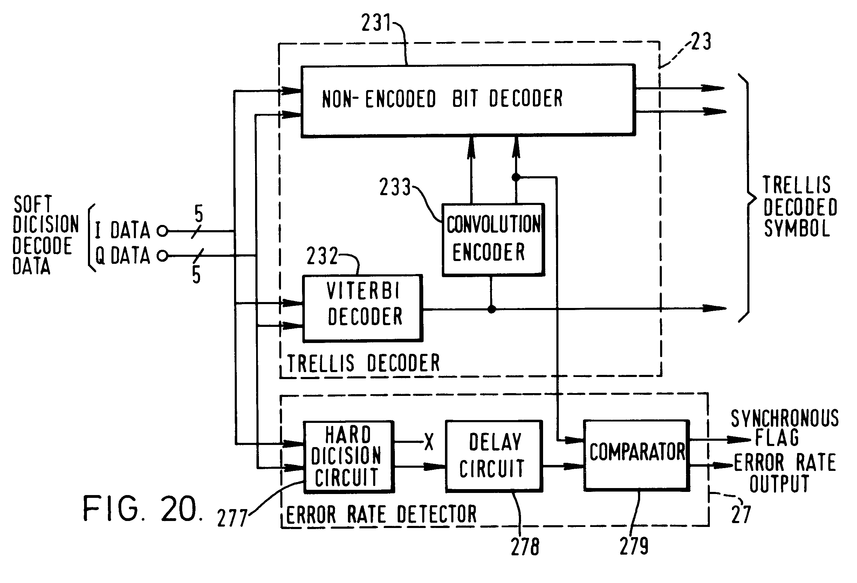

FIGURE 20 is a block diagram showing an example of the structure of an error rate detector of the present invention;

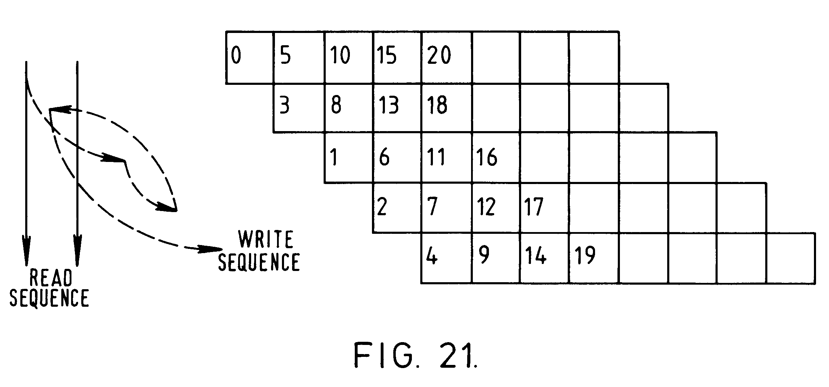

FIGURE 21 is an explanatory diagram showing an oblique interleave involved in the present invention;

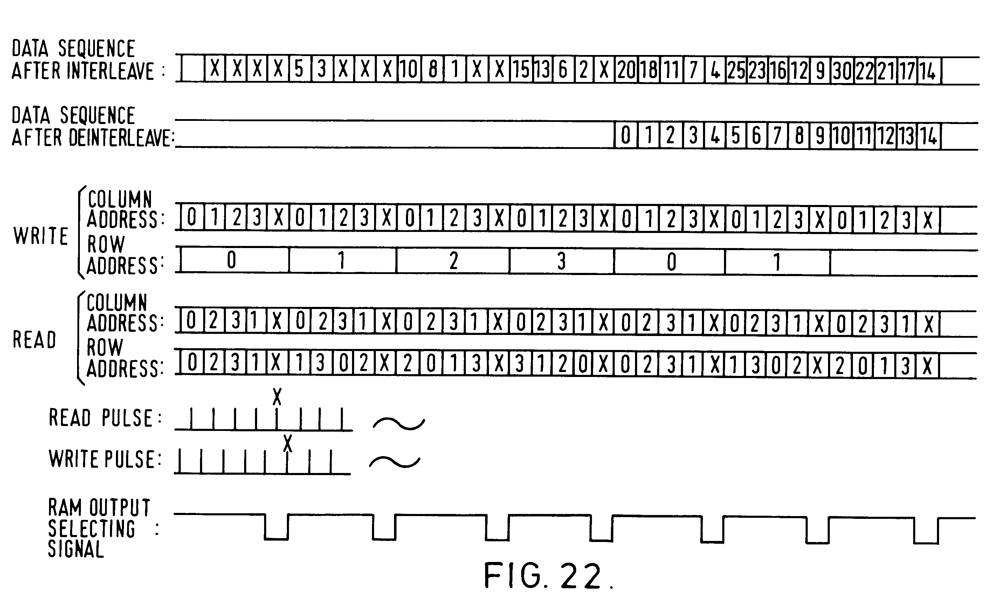

FIGURE 22 is a timing chart showing the address timing of the deinterleave of the present invention;

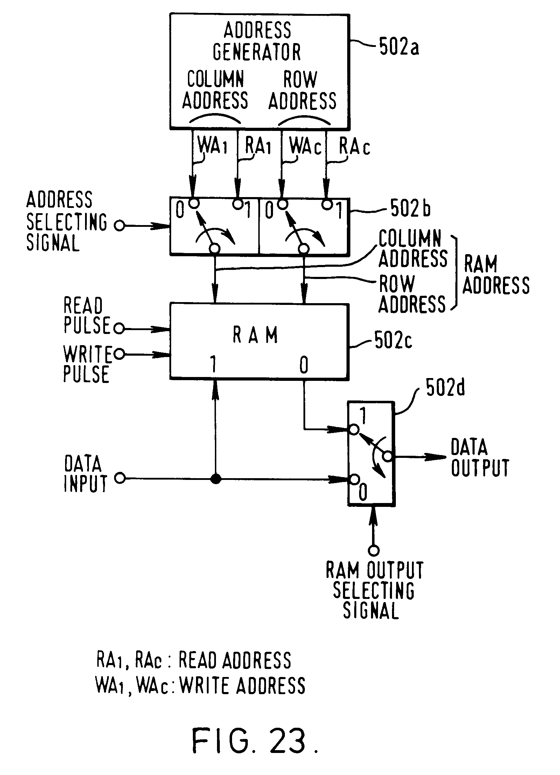

FIGURE 23 is an explanatory diagram showing conventional oblique interleave blocks;

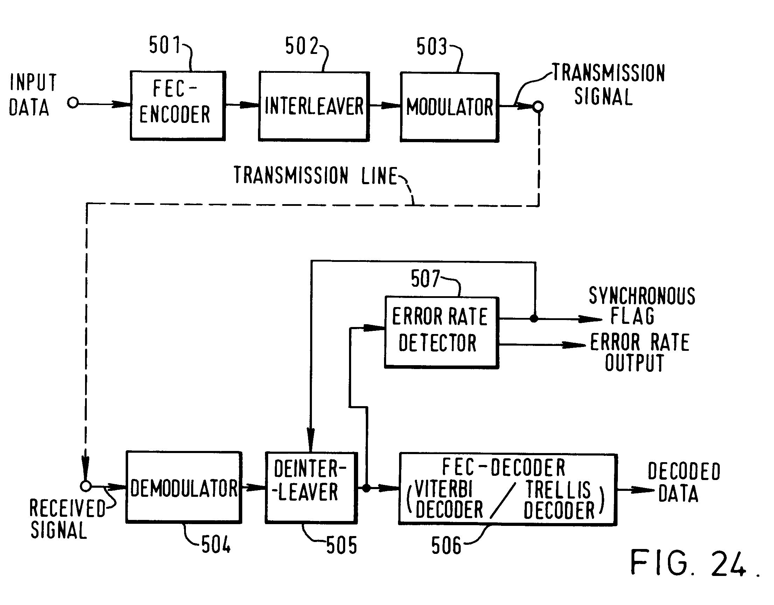

FIGURE 24 is a block diagram showing the outline of the structures of the transmitter and receiver when using the interleave;

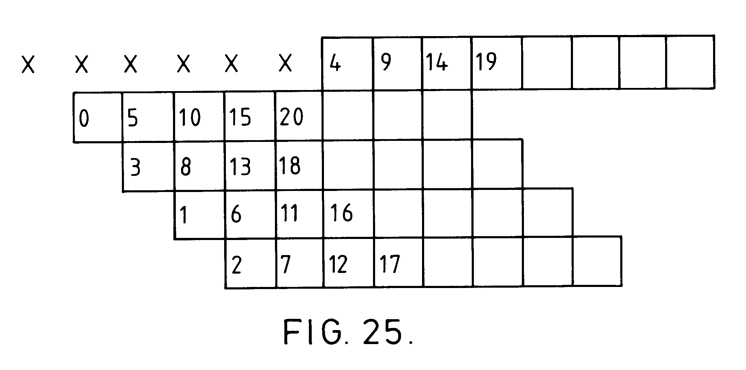

FIGURE 25 is an explanatory diagram showing data when the data sequences shown in FIGURE 21 shifted in the row direction;

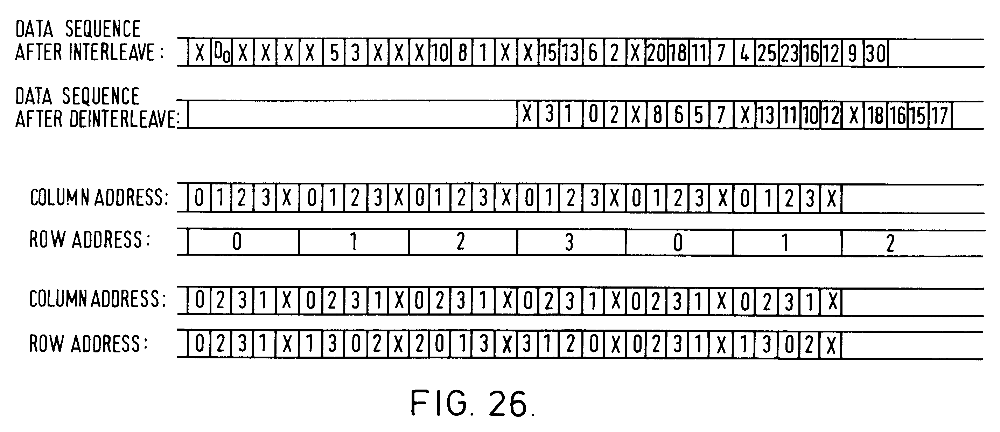

FIGURE 26 is a timing chart showing the relation of data when one deinterleave block of the present invention is shifted;

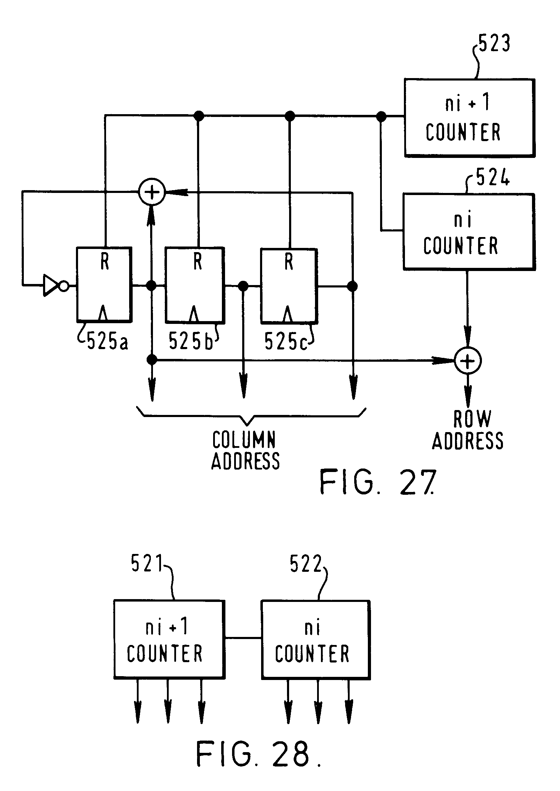

FIGURE 27 is a block diagram showing the structure of the read address generator involved in the present invention;
FIGURE 28 is a block diagram showing the structure of the write address generator involved in the present invention;

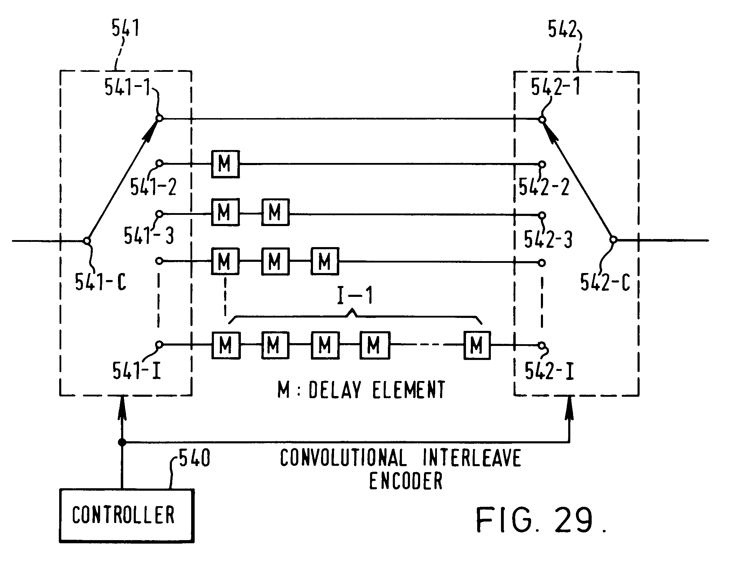

FIGURE 29 is a block diagram showing the structure of the encode in the convolutional interleave; and

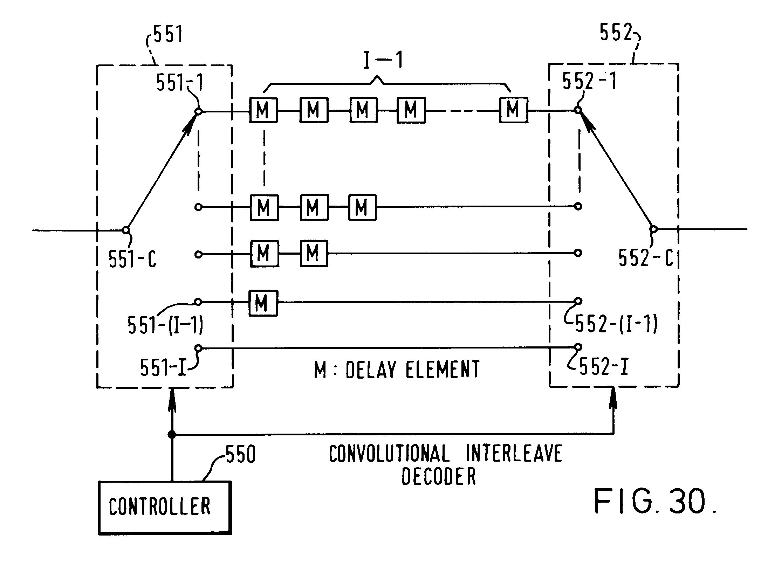

FIGURE 30 Is a block diagram showing the structure of the decoder in the convolutlonal interleave.

Referring to the drawings, preferred embodiments of the present invention will be described in the following.

First, in reference to FIGURE 9, a first embodiment will be explained.

FIGURE 9 is a diagram showing a structural example of the interleave blocks involved in the present invention and shows an oblique interleave system when the interleave depth ni is 3. If a memory has a capacity for minimum 9 symbols (= ni x ni symbols) as shown in FIGURE 10, it is sufficient to achieve the deinterleave. The data sequences after the interleave at this time is shown in FIGURE 11.

As clear from FIGURE 11, a distance of more than ni (= 3) has been secured at all positions including the boundary lines of the interleave blocks (block size: 4 symbols = (ni + 1) in this embodiment.

When referring to an example of read addresses and write addresses shown in FIGURE 11, for the proper deinterleave, it is sufficient if the leading row of the interleave matrix agrees with the leading row of the memory shown in FIGURE 9, they may be out of place in the column direction. For instance, as shown in FIGURE 12, even when one row is shifted, only one column address of the memory addresses for data is shifted when compared with the example shown in FIGURE 9 and the deinterleaved data sequences are free from any effect as shown in FIGURE 13. Accordingly, uncertainty on the synchronization of interleave blocks is 4 (= ni + 1) only for the row direction and when establishing the synchronization of interleave blocks in the structure shown in FIGURE 7 according to the symbol shift method, it is achieved by 3 (= ni) times of the shift operation in the worst case.

Further, as a method for detecting error rates, there is a method of estimating the error rate from the most-likelihood path-metric of the Viterbi decoding in addition to the structure shown in FIGURE 8.

Next, a second embodiment will be explained.

FIGURE 14 is a structural example around the inner FEC-encoder when the Trellis encoded modulation was applied for the inner encodes and the RS symbol modulation system was applied for the outer encodes.

Hereinafter, the structure will be briefly explained. A rate converter 11 changes the rate from 8 bits to 3 bits and 8-bit Reed-Solomon symbol data is input thereto. Trellis encoded input information symbols are input to a Trellis encoder 13. This Trellis encoder is comprised of a convolutional encoder 131 and a signal arranging distributor 133. Trellis encoded modulation symbols Ii, Qi, the outputs of the Trellis encoder 13, are input to an interleaver 15 and after interleaved, output to a 16-QAM modulator as modulated symbols I, Q. The rate converter 11 and the interleaver 15 are connected to a timing generator 17 for synchronization.

The number of bits per encoded symbol of RS symbol that is most often used in the inner FEC-encoder in such structure is 8 bits. On the other hand, the Trellis encoded modulation system in this embodiment uses a 16-QAM and the number of bits per Trellis encoded symbol, that is, Trellis encoded modulation bits is 4 bits and information bits contained in Trellis encoded input are 3 bits. It is therefore necessary to change rate from 8 bits to 3 bits.

When comprising the interleave blocks by 8 Trellis encoded modulation symbols, 3 x 8 = 24 information bits per interleave block are contained in Trellis encoded input. This information bits are equivalent to 3 RS symbols. So, the timing generator 17 operates so that, for instance, 3 RS symbols in the input are contained in each interleave block.

FIGURE 15 is an example of the structure around the inner FEC-decoder corresponding to FIGURE 14. This structure will be briefly explained in the following. A de-interleaver 21 is to perform the deinterleave and modulated symbols I, Q are input thereto from a 16-QAM modulator. Trellis encoded modulation symbols Ii, Qi which are output from this de-interleaver 21 are input to a Trellis decoder 23 and an error rate detector 27. Trellis decoded symbol that is output rrom this Trellis decoder 23 is input to a rate converter 25 and Viterbi decoded bit out of this Trellis decoded symbol is input to the error rate detector 27. A synchronous flag that is output from the error rate detector 27 is input to a timing generator 29 for synchronization of the interleaver 21 and the rate converter 25. Further in the rate converter 25, the rate is changed from 3 bits to 8 bits and 8-bit Reed-Solomon decoded data is output.

In the inner FEC-decoder in such the structure as described above, Viterbi decoded bit contained in 3 bits of Trellis decoded symbol that is output from the Trellis decoder 23 is 1 bit. From this bit, Ii data and Qi data that are input to the Trellis decoder 23, an error rate is estimated by the error rate detector 27 and if the detected error rate is above a preset value, the synchronous flag that is output to a timing generator 29 is lowered to show the asynchronous state. The timing generator 29 inputs this synchronous flag to the de-interleaver 21 and shifts the timing by 1 symbol. This operation is repeated until an error rate becomes smaller than a preset value.

The timing control (address control) in the de-interleaver 21 contains an interleave block period (for 8 demodulated symbols). At this time, as Trellis decoded symbols contained in the interleave block synchronization are also 8 symbols, total 24 bits are contained in the timing control. When outputting RS decoded input data in a unit of 1 bite, by taking out 8 bits from the top of 14 bits at a time as decided above (by the 3-bit to 8-bit rate converter 25), it is possible to detect and decide the boundary of bytes without especially providing a byte synchronizer.

It is not always necessary to bring the boundary of bytes to agree with the boundary of the interleave blocks and they may obtain out of position by, for instance, 1 bit if it has been so decided between the sending and receiving sides.

Further, in the case where a unit of inner FEC-decoded symbols is 2 bits, the interleave block length can be a multiple of 4 symbols. At this time, if the interleave block length is 4 symbols, one synchronization of the interleave blocks contains FEC-decoded 4 symbols = 8 bits, which may be directly used as RS decoded input data.

In general, when a unit of the inner FEC-decoding is m0 bit, it is sufficient if ns x m0 is divided by the outer FEC-decoding unit for the interleave block length ns.

When the oblique interleave shown in FIGURE 9 is used, as the interleave depth is (ns-1) for the interleave block length ns satisfying this condition, that is, "when unit of the inner FEC-decoding is m0 bit, it is sufficient if ns x m0 is divided by the outer FEC-docoding unit for the interleave block length ns", a required interleave depth ni should be so selected that ni becomes less than or equal to (ns - 1).

In case of the type of interleave shown in FIGURE 2, the byte synchronization also can be established and as the depth of interleave is the root of (ns) for the interleave block length, a required interleave depth ni should be so selected that ni becomes less than or equal to the root of (ns). However, if the root of (ns) is not an integer, the interleave blocks may not be a square but the number of rows and columns must be more than ni.

FIGURE 16 shows minimum values of the interleave block length when ns can be 56 against a required interleave depth is ni = 5 if a unit of the inner FEC-decoding is not a divisor of 8 (the rate conversion output unit).

FIGURE 17 shows an example of the interleave system disclosed in the U.S. Patent 4,559,625 modified and applied to the present invention. Here, the interleave blocks are comprised by forming sub-blocks of (ni + 1) in the column direction against the required interleave block depth ni and interleaving the ni rows obliquely. This system has an effect to minimize the memory and is usable to the byte synchronization at ns = 56 (as a coefficient of 8).

Further, when compared with FIGURES 16 and 18, the interleave block length is ns + 56 against the same Interleave depth ni = 7. It is clear that the oblique interleave is more advantageous as far as the rate of establishing the interleave block synchronization is concerned.

Next, a third embodiment will be explained.

The third embodiment achieves the error rate detection (estimation) without using a simple decoder 470 shown in FIGURE 8.

First, in reference to FIGURE 19, the structure of the error rate detector of the present invention corresponding to FIGURE 8 will be explained.

Soft decision demodulated data D1/D2 is input to a Viterbi decoder 274 and high order 1 bit (the hard decision result) of this soft decision demodulated data D1/D2 is input to a delay circuit 271 or 275. Further, Viterbi decoded data is output from the Viterbi decoder 274 and this Viterbi decoded data is also output to convolutional encoder 273. The output of this convolutional encoder 273 and the delay circuit 271 or 275 are supplied to comparators 272, 276, respectively, where the comparison and decision are performed and the decision results are output as a synchronous flag and an error rate output.

The modulation by the error rate detector as shown in FIGURE 19 is BPSK, the Viterbi decoding is performed in the Viterbi decoder 274 using the soft decision demodulated data D1/D2 for two demodulated symbols. The Viterbi decoded data thus obtained is supplied to the convolutional encoder 273 where a decoded convolutional encoded bit is reproduced by convolutionary encoding it again.

On the other hand, as high order 1 bit of the soft decision demodulated data D1 or D2 is a hard decision result, it is possible to estimate an error rate by delaying the data in the delay circuit 271 or 275 by a time required for the Viterbi decoding in the Viterbi decoder 274 and by comparing it with the corresponding convolutionary encoded bit previously obtained, count the number of disagreed bits and obtaining the disagreed bit generating frequency.

Further, if C/N is sufficient, an error rate of Viterbi decoded bit is sufficiently smaller than the error rate of the disagreed bit and negligible. Therefore, the disagreed bit generating frequency agrees with the hard decision bit error rate and it is possible to estimate an error rate of Viterbi decoded data therefrom.

FIGURE 20 shows an error rate detector for the Trellis encoded modulation system. First, in reference to FIGURE 20, the structure of this error rate detector will be explained.

5-bit soft decision demodulated data I, Q are input to the Trellis decoder 23 and the error rate detector 27, respectively. This Trellis decoder 23 is comprised of an non-coded bit decoder 231, a Viterbi decoder 232 and a convolutional encoder 233 while the error rate detector 27 is comprised of a hard decision circuit 277, a delay circuit 278 and a comparator 279.

The convolution encoder 233 in the Trellis decoder 23 is to decode non-coded bits and the output (reproduced convolutional encoded bits) from this encoder is usable for the error rate detection.

Further, as the soft decision demodulated data I, Q that are input to the Trellis decoder 23 are data arranged directly corresponding to the mapping of I/Q axis, a hard decision circuit becomes necessary for hard decision of convolutional encoded bits. This circuit is achieved by a decoder using a ROM.

Further, in the first and the second embodiments, disagreement frequency exceeds a prespecified value, it is possible to show the asynchronous state by lowing the synchronous flag. It is also possible to use this in establishing the interleave block synchronization shown in FIGURE 15.

Further, by providing two kinds of prespecified values, if a random asynchronous state is produced, it is possible to stabilize the generation of a synchronous flag by giving the hysteresis characteristic so that the synchronous flag is set at a lower value.

Further, for the comparison and decision, all of the convolutional encoded bits are usable but when the delay circuit 271 and the comparison/decision circuit shown in FIGURE 19 and part of the bits are used as shown in FIGURE 20, the delay circuit can be made small in scale.

In the embodiments shown above, a case where the convolutional encoding rate is r = 1/2 is shown and it is clear that this invention is applicable even when a encoding rate is r = 2/3. Further, when the synchronous flag shows the asynchronous state, the reliability of the Trellis decoded symbol is low and it is therefore possible to use it as an outer encode vanishing flag. Further, the byte synchronization may be required when FEC-decoded data is connected to ATM.

According to the embodiments of the present invention as descibed above, it is possible to obtain an interleave distance even at the boundary line of the interleave blocks, thus speeding up the term for achieving the synchronous state. Furthermore, it is possible to use the interleave block timing for the rate conversion after FEC-decoded output for the output synchronization. In addition, the error rate detection and estimation can be achieved without using a simple decoder.

Another preferred embodiment of the present invention will be explained referring to the attached drawings FIGURES 21 through 27.

FIGURE 21 is an explanatory diagram showing the oblique interleave involved in this embodiment. In the embodiment as explained above, data sequences were written sequentially in the oblique direction. In this embodiment, however, data sequences are written in the oblique direction after rearranging the sequence. In FIGURE 22, the data sequences after the interleave and deinterleave and the RAM controlled timing shown in FIGURE 23 are shown. Here, for convenience, RAM addresses are divided into row addresses and column addresses corresponding to the rows and sequences of the interleave matrix. This example minimized the delay of the deinterleaver and the RAM output selecting signal becomes "0" for every 5 symbols, and data input becomes directly data output in FIGURE 22.

As shown in FIGURE 21, the oblique arranging order is 0, 3, 1, 2, 4. Unless the first and the last positions (0 and 4 in this case) are not changed, the delay becomes minimum. Further, when the deinterleave is performed at the receiver side, it is required to decide the synchronization of interleave blocks. This is because the deinterleaver is not properly carried out if the top position of the interleave blocks is not in accord with the top position of the address control for the deinterleave.

Regarding this, if an error rate detected by the error detector 507 shown in FIGURE 24 is large, the synchronization is decided while shifting the top position of the deinterleave in the deinterleaver 505 as in a conventional example. Further, the detection of an error rate through the comparison of the encoded result by the simple decoder 470 with the decoded result by the Viterbi decoder 474 is the same as before in reference to FIGURE 8.

Based on the above, the operation of the system and apparatus in this embodiment will be explained in the following. In this embodiment, the sequence of data sequences has been rearranged when obliquely writing them into a memory as shown in FIGURE 21. That is, the data are written in order of 0, 3, 1, 2, 4, 5, 8, 6 and so on and read out in order of 0, x, x, x, x, 5, 3, x, x, x, 10, 8, 1, x, x, 1, 5, 13 and so on.

Now, if the data sequences are shifted by one in the row direction, the data become as shown in FIGURE 25 and after the deinterleave, they become as shown in FIGURE 26. That is, they become in order of x, 0, 3, 1, 2, x, 5, 8, 6, 7, x, 10 and so on. Thus, this data sequences large differ from the proper data sequences. Accordingly, it becomes possible for the error rate detector 507 as shown in FIGURE 24 to easily detect whether the error is the synchronizing error in the deinterleave or a transmission error during the transmission. The actual tests by the inventor and others confirmed that a difference between the deinterleave starting position error and the error by noise in a transmission line becomes about 2 dB.

One example of an address generator in the interleave and the deinterleavers when ni = 7 is shown in FIGURES 27 and 28. The write addresses (FIGURE 28) are composed by counters, that is, the row counter is composed of the ni+1 counter 521 and the sequence counter is composed of the ni counter. The read addresses (FIGURE 27) are the flip-flops 525a through 525c which generate pseudo-random addresses by generating PN symbol through generation of the M series. The row addresses are reset by a signal from the ni+1 counter 523 at the ni+1 period. These flip-flops 525a through 525c are reset in synchronism with clocks by a signal from the ni+1 counter and generate row addresses.

The ni counter 524 counts up once at ni+1 times from the counter 523 and the column address generator outputs an added value of the row address and the ni counter 524 as a column address.

In this example, it is possible to use the ni+1 counter 523 for generating the read address also as the write address generating ni+1 counter 521 and the read address generating ni counter 524 as the write address generating ni+1 counter 522.

The counters are able to count down as a matter of course not only to count up. This also applies to other cases than ni = 7. Further, the PN symbol generator may be other different types without sticking to this example.

The read counter may store read address values shown in FIGURE 27 in a ROM and the like.

Thus, it is possible to perform the oblique interleave by rearranging data sequences at random as shown in FIGURE 21 and furthermore, it is also possible to perform the deinterleave.

Further, by providing prespecified value as a threshold to the comparison by the comparator 472, it is possible to decide whether frequency of disagreement or an estimated error rate is above this threshold and if this threshold is exceeded, it is possible to show the asynchronous state by lowering the synchronizing flag.

Further, it is also possible to give a hysteresis characteristic to the comparator by providing two kinds of different thresholds and selecting these values according to the asynchronous and synchronous state, thus stabilizing the generation of the synchronizing flag. That is, in the case of asynchronous state, thresholds are set at a lower level when it is difficult to judge whether it is due to a data error resulting from the deinterleave starting position or the transmission error due to noise and the thresholds are set at a higher level after the deinterleave is synchronized as the possibility for step-out of the synchronization is extremely low.

Further, while an error rate is detected using the Viterbi decoder 474 in FIGURE 8, there is also a method to estimate it from the most excellent bus metric. If there is an error, as a measured value of Hamming distance of symbols or logarithm tolerance function may cause an overflow, it is necessary to periodically lower the value aid by measuring this frequency an error rate can be estimated. Or as the most excellent bus metric value is correlative to C/N, there is a method to use this correlation (Japanese Patent, Tokkou-Hei No. 4-10773).

Next, an embodiment with the transmission system, the encoder and the decoder of the present invention applied to a transmission system, an encoder and a decoder accompanying the rate conversion will be explained. The whole structure of the transmission system accompanying the rate conversion is the same as that explained in FIGURE 1 as far as the conventional technique is concerned, FIGURES 29 and 30 are block diagrams showing the structures of the encoder and the decoder in the convolutional interleave, respectively. In FIGURE 29, the encoder used for the interleave at the transmitting section is provided with two selectors 541 and 542 to select contacts which are sequentially connected at the same phase and the same period I according to the control from the controller 540 and a delay circuit provided between the contacts of two selectors, which are opposing to each other in which a delay time increases sequentially.

The selectors 541 and 542 have common contacts 541-C and 542-C and I pieces of contacts 541-1 (Contact No. 1). 541-2 (Contact No. 2 and so on). .... 541-I and 542-1 (Contact No. 1), 542-2 (Contact No. 2 and so on). .... 542-I which are selectively connectable to the common contacts 541-C and 541-2, and select contacts which are sequentially connected at the same phase and the same period I. The delay circuit provided between the selectors 541 and 542 is a circuit with (Contact No. 1) pieces delay elements M arranged in series each of which delays a signal by (Contact No. 1) x M. That is, in a first bus provided between Contacts No. 1 of respective selectors, a signal input to the selector 41 is output without delay but in a second bus it is delayed by M. As this delay is made assuming I period as 1 sample, the input signal is delayed by I x M as a result. Thereafter, signals are output after delayed by I x 2M. I xn 3M. .... I x (I-1)M.

In FIGURE 30, the decoder used for the deinterleave at the receiving section is comprised of two selectors 551 and 552, each of which has common contacts 551-C, 552-C and I pieces of contacts which are selectively connectable to the common contacts 551-C, 552-C and selects contacts sequentially connected at the same phase and the same period I and a delay circuit provided between the mutually opposing contacts of the selectors 551, 552 to decrease a delay time sequentially. That is, in the first bus the signal input to the selector 551 is delayed by I x (I-1)M and output. In the second bus the signal is delayed by I x (I-2)M. Thereafter, signals are delayed by I x (I-3)M. .... I x M. 0, and output. Therefore, the decoder restores the symbol sequences by performing the operation reverse to the encoder.

The convolutional interleave is described in detail in G. D. Forney Jr. "Burst-Correcting encodes for the Classic Bursty Channel" IEEE. TRANS. on COMM. TECH. Vol. COM-19. No. 5. Oct. 1971.

In the interleave blocks by the oblique interleave as shown in FIGURE 9 or in the convolutional interleave as shown in FIGURE 29, even when the top positions of interleave blocks in size ns are not in accord with each other or shifted in the column direction, the proper deinterleave is possible. Regarding this point, assuming that the vertical length of interleave blocks, that is, if the number of rows of an interleave matrix is assumed at I, the rate of symbol sequences that are input in a unit of n-out bits is changed and I, m0 and n-out are set so that a product of I and m0 can be divided by n-out, it becomes possible to synchronize bits without using a synchronous symbol. When compared with the setting of ns, m0 and n-out to obtain a divisible product of ns x m0 by n-out assuming a block size used for the conventional blook interleave as ns, it becomes possible to use a value of more loose restriction and the large degree of freedom.

Further, it is also possible that the selectors shown in FIGURES 29 and 30 select contacts according to arbitrarily set sequences at the same phase and the same period I.

As described above, the present invention is capable of providing an extremely preferable transmission system and apparatus therefor.

Also, the present invention is able to perform the stabilized sync decision even in the more worse C/N state as decoded data sequences after the deinterleave from the shifted deinterleave starting position is differing largely from the proper data sequences and it is easy to decide that an error is due to noise in a transmission line.

Further, if the deinterleave side is not aware of this rearranging order, encoded data cannot be decoded. Thus, it is also possible to obtain an effect to simply apply the scramble.

While there have been illustrated and described what are at present considered to be preferred embodiments of the present invention, it will be understood by those skilled in the art that various changes and modifications may be made, and equivalents may be substituted for elements thereof without departing from the true scope of the present invention. In addition, many modifications may be made to adapt a particular situation or material to the teaching of the present invention without departing from the central scope thereof. Therefor, it is intended that the present invention not be limited to the particular embodiment disclosed as the best mode contemplated for carrying out the present invention, but that the present invention includes all embodiments falling within the scope of the appended claims.

The foregoing description and the drawings are regarded by the applicant as including a variety of individually inventive concepts, some of which may lie partially or wholly outside the scope of some or all of the following claims. The fact that the applicant has chosen at the time of filing of the present application to restrict the claimed scope of protection in accordance with the following claims is not to be taken as a disclaimer or alternative inventive concepts that are included in the contents of the application and could be defined by claims differing in scope from the following claims, which different claims may be adopted subsequently during prosecution, for example, for the purposes of a divisional application.

## Claims

1. Transmission system adaptable for an FEC-encoding system, characterized in that FEC-encoded symbol sequences are obliquely arranged in order when forming interleave blocks by arranging the FEC-encoded symbol sequences in order into a matrix.

2. A transmission system adaptable for an FEC-encoding system, comprising:
a transmitting section in which symbol sequences input in a unit of n-out bits are applied with the rate change from n-out to m0, the FEC-encoded symbol sequence thus obtained are composed to FEC-encoded symbol sequences for every unit of ns symbols, and the interleave symbol sequences are interleaved for transmission; and
a receiving section in which a decoded symbol sequences containing m0 bits per symbol are obtained by carrying out a deinterleaving and a FEC-decoding on a received symbol sequence corresponding to the interleaved symbol sequence in opposite to those in the transmitting section, and the FEC-decoded symbol sequences are converted their data rate from m0 to n-out for outputting by a unit of n-out bits wherein the values of I, m0 and n-out are so defined that the product of the I and m0 are divided by the n-out without a reminder.

3. A transmission system as claimed in claim 2, wherein the interleave block is formed by obliquely arranging the symbol sequence.

4. A transmission system adaptable for an FEC-encoding system, comprising:
an FEC-encoding means for applying the encoding according to a convolutional encoding modulation system or a Trellis encoding modulation system; and
interleave means for composing interleave blocks by sequentially arranging the symbol sequences obtained through the encoding according to the FEC-encoding means.

5. A transmission system adaptable for an FEC-encoding system, comprising:
data rate converting means for converting a data rate of symbol sequence input in a unit of n-out bits from the n-out to m0;
means for FEC-encoding the symbol sequence output from the data rate converting means for every unit of ns symbols;
interleave means for constituting interleaved blocks obtained through the FEC-encoding by dividing the symbol sequence into every unit of ns symbols and then constituting an interleave matrix with I columns by carrying out an oblique arrangement for every interleave block for transmitting the interleaved symbol sequence;
wherein the values of I, m0 and n-out are so defined that the product of the I and m0 are divided by the n-out without a reminder.

6. A transmission system as claimed in claim 5, wherein the interleave means carries out the interleave for forming the interleave block by obliquely arranging the symbol sequence.

7. A decoder in a receiver for decoding FEC-encoded symbol sequence encoded in an FEC-encoding system in obliquely arranged in sequential order, comprising:
deinterleave means for carrying out deinterleave for data sequence corresponding to the interleave symbol sequences;
means for FEC-decoding the output from the deinterleave means; and
error rate detecting means for detecting an error rate of the symbol sequences obtained by the deinterleave means and the FEC-decoding means, and then establishing a synchronous flag corresponding to the detected error rate,
wherein, the deinterleaving means establishes synchronization of interleave blocks by shifting the interleave timing when the synchronous flag indicates an asynchronous state.

8. A decoder in a receiver for decoding interleaved symbol sequence which is processed a data rate conversion on symbol sequence input in a unit of n-out bits from the n-out to m0, FEC-encoding on the symbol sequence obtained by the data rate conversion for every unit of ns symbols, and interleaving for constituting interleaved blocks obtained through the FEC-encoding by dividing the symbol sequence into every unit of ns symbols, characterized in that it comprise:
deinterleave means for carrying out a deinterleave for data sequence corresponding to the interleave symbol sequences, means for FEC-decoding the output from the deinterleave means;
data rate converting means for outputting the output of the FEC-encoding means in a unit of n-out bits after changing the rate from m0 to n-out; and
error rate detecting means for detecting an error rate of the symbol sequences obtained by the deinterleave means and the FEC-decoding means, and then establishing a synchronous flag corresponding to the detected error rate,
and wherein the deinterleaving means establishes synchronization of interleave blocks by shifting the interleave timing when the synchronous flag indicates an asynchronous state.

9. A decoder as claimed in claim 8, wherein the deinterleave means carries out the deinterleave on data sequence corresponding to the interleave symbol sequence by obliquely arranging the symbol sequence obtained by the FEC-encoding.

10. A decoder as claimed in claim 7, wherein the error rate detecting means comprises:
a convolutional encoder for outputting the whole or part of the convolutionary encoded bits of Viterbi decoded bits obtained through the Viterbi decoding of FEC-decoded symbols;
a hard decision circuit for outputting hard decision encoded bits by hard deciding the FEC-decoded symbols;
a delay circuit for delaying the hard decision encoded bits by a time required for the Viterbi decoding; and
a comparator means for counting the number of disagreed bits between the hard decision encoded bits output from the delay circuit and the encoded bits output from the convolution encoder and estimating and outputting an error rate from the frequency of disagreement.

11. A decoder as claimed in claim 8, wherein the error rate detecting means comprises:
a convolutional enooder for outputting the whole or part of the convolutionary encoded bits of Viterbi decoded bits obtained through the Viterbi decoding of FEC-decoded symbols;
a hard decision circuit for outputting hard decision encoded bits by hard deciding the FEC-decoded symbols;
a delay circuit for delaying the hard decision encoded bits by a time required for the Viterbi decoding; and
a comparator means for counting the number of disagreed bits between the hard decision encoded bits output from the delay circuit and the encoded bits output from the convolution encoder and estimating and outputting an error rate from the frequency of disagreement.

12. A decoder as claimed in claim 10, wherein the comparator means determines whether the frequency of disagreements or the estimated error rate exceeds a prespecified threshold value and outputs a synchronous flag showing the synchronous state.

13. A decoder as claimed in claim 11, wherein the comparator means determines whether the frequency of disagreements or the estimated error rate exceeds a prespecified threshold value and outputs a synchronous flag showing the synchronous state.

14. A decoder as claimed in claim 12, wherein the comparator means provides two kinds of prespecifled thresholds and selects these thresholds properly according to the asynchronous state and the synchronous state.

15. A decoder as claimed in claim 13, wherein the comparator means provides two kinds of prespecified thresholds and selects these thresholds properly according to the asynchronous state and the synchronous state.

16. A decoder as claimed in claim 7, wherein the FEC-decoding means is provided for an articulation-encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

17. A decoder as claimed in claim 8, wherein the FEC-decoding means is provided for an articulation-encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

18. A decoder as claimed in claim 9, wherein the FEC-decoding means is provided for an articulation-encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

19. A decoder as claimed in claim 10, wherein the FEC-decoding means is provided for an articulation-encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

20. A decoder as claimed in claim 11, wherein the FEC-decoding means is provided for an articulation-encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

21. A decoder as claimed in claim 12, wherein the FEC-decoding means is provided for an articulation-encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

22. A decoder as claimed in claim 13, wherein the FEC-decoding means is provided for an articulatlon-encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

23. A decoder as claimed in claim 14, wherein the FEC-decoding means is provided for an articulation-encoding of the convolutional encoded modulation system or the Trellis encoded modulation system as the inner encode combined with block encodes as the outer encodes and the synchronous flag output from the error rate detecting means is carried out a vanish-correction as a vanish flag of thc outcr block encodes at the outer FEC-decoding.

24. A decoder as claimed in claim 15, wherein the FEC-decoding means is provided for an articulation-encoding of the convolutional encoded modulation system or the Trellis encoded modulation system as the inner encode combined with block encodes as the outer encodes and the synchronous flag output from the error rate detecting means is carried out a vanish-correction as a vanish flag of the outer block encodes at the outer FEC-decoding.

25. In a transmission system for information transmission by applying the interleave for every interleave blocks after arranging FEC-encoded symbol sequences according to the FEC-encoding system in a matrix, it is characterized in that the symbol sequences are arranged for every interleave blocks in arbitrarily set arranging order for the interleaving operation.

26. In a transmission system for information transmission by applying the oblique interleave for every interleave blocks after composing interleave blocks by sequentially arranging FEC-encoded symbol sequences according to the FEC-coding system in an oblique matrix, it is characterized in that the symbol sequences for respective interleave blocks are arranged in arbitrarily set arranging order for composing the oblique interleave blocks.

27. A transmission system for information transmission as claimed in claim 15, the arbitrarily set symbol arranging order is determined by a PN symbol (Pseudo-random number symbol).

28. A transmission system for information transmission as claimed in claim 26, the arbitrarily set symbol arranging order is determined by a PN symbol.

29. A transmission system for information transmission as claimed in claim 25, the arbitrarily set symbol arranging order is used for rearranging symbols except the first and the last symbols composing the interleave blocks.

30. A transmission system for information transmission as claimed in claim 26, the arbitrarily set symbol arranging order is used for rearranging symbols except the first and the last symbols composing the interleave blocks.

31. A transmission system for information transmission as claimed in claim 27, the arbitrarily set symbol arranging order is used for rearranging symbols except the first and the last symbols composing the interleave blocks.

32. A transmission system for information transmission as claimed in claim 27, the arbitrarily set symbol arranging order is used for rearranging symbols except the first and the last symbols composing the interleave blocks.

33. An encoder for interleaving FEC-encoded symbol sequence for transmission, comprising:
an FEC-encoding means for applying the encoding according to a convolutional encoding modulation system or a Trellis encoding modulation system; and
means for composing interleave blocks by sequentially arranging the symbol sequences obtained through the encoding according to the FEC-encoding means in a matrix after arbitrarily converting the arranging order.

34. An encoder for interleaving an FEC-encoded symbol sequence for transmission, comprising:
FEC-encoding means for performing the encoding according to a convolutional encoding system or a Trellis encoding modulation system; and
means for composing interleave blocks by obliquely arranging the symbol sequences obtained by encoding by the FEC-encoding means after arbitrarily converting the arranging order of symbols for every specified number of symbols.

35. An encoder as claimed in claim 33, wherein the symbol arranging order is decided by a PN symbol.

36. An encoder as claimed in claim 34, wherein the symbol arranging order is decided by a PN symbol.

37. An encoder as claimed in claim 33, wherein the symbol arranging order is rearranged except the first and the last symbols of the interleave blocks.

38. An encoder as claimed in claim 34, wherein the symbol arranging order is rearranged except the first and the last symbols of the interleave blocks.

39. A decoder for decoding symbol sequence encoded by an encoder as defined by claim 33, by deinterleaving and decoding the symbol sequences, comprising:
deinterleave means for deinterleaving the interleaved symbol sequences in the changed sequence;
error rate detecting means for detecting an error rate of the symbol sequences obtained by the deinterleave means; and
means for supplying the interleaved symbol sequences to the deinterleave means again by sequentially shifting the deinterleave timing by the deinterleave means when the detected error rate exceeds a specified value.

40. A decoder for decoding symbol sequence encoded by an encoder as defined by claim 34, by deinterleaving and decoding the symbol sequences, comprising:
deinterleave means for deinterleaving the interleaved symbol sequences in the changed sequence;
error rate detecting means for detecting an error rate of the symbol sequences obtained by the deinterleave means; and
means for supplying the interleaved symbol sequences to the deinterleave means again by sequentially shifting the deinterleave timing by the deinterleave means when the detected error rate exceeds a specified value.

41. A decoder for decoding symbol sequence encoded by an encoder as defined by claim 35, by deinterleaving and decoding the symbol sequences, comprising:
deinterleave means for deinterleaving the interleaved symbol sequences in the changed sequence;
error rate detecting means for detecting an error rate of the symbol sequences obtained by the deinterleave means; and
means for supplying the interleaved symbol sequences to the deinterleave means again by sequentially shifting the deinterleave timing by the deinterleave means when the detected error rate exceeds a specified value.

42. A decoder for decoding symbol sequence encoded by an encoder as defined by claim 36, by deinterleaving and decoding the symbol sequences, comprising:
deinterleave means for deinterleaving the interleaved symbol sequences in the changed sequence;
error rate detecting means for detecting an error rate of the symbol sequences obtained by the deinterleave means; and
means for supplying the interleaved symbol sequences to the deinterleave means again by sequentially shifting the deinterleave timing by the deinterleave means when the detected error rate exceeds a specified value.

43. A decoder for decoding symbol sequence encoded by an encoder as defined by claim 37, by deinterleaving and decoding the symbol sequences, comprising:
deinterleave means for deinterleaving the interleaved symbol sequences in the changed sequence;
error rate detecting means for detecting an error rate of the symbol sequences obtained by the deinterleave means; and
means for supplying the interleaved symbol sequences to the deinterleave means again by sequentially shifting the deinterleave timing by the deinterleave means when the detected error rate exceeds a specified value.

44. A decoder for decoding symbol sequence encoded by an encoder as defined by claim 38, by deinterleaving and decoding the symbol sequences, comprising:
deinterleave means for deinterleaving the interleaved symbol sequences in the changed sequence;
error rate detecting means for detecting an error rate of the symbol sequences obtained by the deinterleave means; and
means for supplying the interleaved symbol sequences to the deinterleave means again by sequentially shifting the deinterleave timing by the deinterleave means when the detected error rate exceeds a specified value.

45. A decoder as claimed in claim 39, wherein the error rate detecting means contains:
Viterbi decoding means for Viterbi-decoding the deinterleaved symbol sequences;
simple decoding means for simply decoding the deinterleaved symbol sequences; and
comparator means for detecting an error rate by comparing the decoded result by the Viterbi decoding means with the decoded result by the simple decoding means.

46. A decoder as claimed in claim 40, wherein the error rate detecting means contains:
Viterbi decoding means for Viterbi-decoding the deinterleaved symbol sequences;
simple decoding means for simply decoding the deinterleaved symbol sequences; and
comparator means for detecting an error rate by comparing the decoded result by the Viterbi decoding means with the decoded result by the simple decoding means.

47. A decoder as claimed in claim 41, wherein the error rate detecting means contains:
Viterbi decoding means for Viterbi-decoding the deinterleaved symbol sequences;
simple decoding means for simply decoding the deinterleaved symbol sequences; and
comparator means for detecting an error rate by comparing the decoded result by the Viterbi decoding means with the decoded result by the simple decoding means.

48. A decoder as claimed in claim 42, wherein the error rate detecting means contains:
Viterbi decoding means for Viterbi-decoding the deinterleaved symbol sequences;
simple decoding means for simply decoding the deinterleaved symbol sequences; and
comparator means for detecting an error rate by comparing the decoded result by the Viterbi decoding means with the decoded result by the simple decoding means.

49. A decoder as claimed in claim 43, wherein the error rate detecting means contains:
Viterbi decoding means for Viterbi-decoding the deinterleaved symbol sequences;
simple decoding means for simply decoding the deinterleaved symbol sequences; and
comparator means for detecting an error rate by comparing the decoded result by the Viterbi decoding means with the decoded result by the simple decoding means.

50. A decoder as claimed in claim 44, wherein the error rate detecting means contains:
Viterbi decoding means for Viterbi-decoding the deinterleaved symbol sequences;
simple decoding means for simply decoding the deinterleaved symbol sequences; and
comparator means for detecting an error rate by comparing the decoded result by the Vitebi decoding means with the decoded result by the simple decoding means.

51. A transmission system for interleaving FEC-encoded symbol sequences for transmission, comprising:
a transmitting section in which symbol sequences input in a unit of n-out bits are applied with the rate change from n-out to m0, the FEC-encoded symbol sequence thus obtained are composed to FEC-encoded symbol sequences for every unit of ns symbols, an interleave matrix of the number of rows I is formed by obliquely arranging every interleave blocks, and the interleave symbol sequences are interleaved for transmission; and
a receiving section in which a decoded symbol sequences containing m0 bits per symbol are obtained by carrying out a deinterleaving and a FEC-decoding on a received symbol sequence corresponding to the interleaved symbol sequence in opposite to those in the transmitting section, and the FEC-decoded symbol sequences are converted their data rate from m0 to n-out for outputting by a unit of n-out bits wherein the values of I, m0 and n-out are so defined that the product of the I and m0 are divided by the n-out without a reminder.

52. An encoder for interleaving FEC-encoded symbol sequences for transmission, comprising:
data rate conversion means for converting the rate of symbol sequences input in a unit of n-out bits from n-out to m0;
FEC-encoding means for carrying out the FEC-encoding to the symbol sequences output from the data rate conversion means for every m0 bits; and
interleave means for constituting interleaved blocks obtained through the FEC-encoding by dividing the symbol sequence into every unit of ns symbols and then constituting an interleave matrix with I columns by carrying out an oblique arrangement for every interleave block for transmitting the interleaved symbol sequence;
wherein the values of I, m0 and n-out are so defined that the product of the I and m0 are divided by the n-out without a reminder.

53. A decoder for decoding an interleaved symbol sequence encoded by the encoder for transmission as defined by claim 52, comprising:
deinterleave means for carrying out a deinterleave opposite to those in the transmitting section on the received symbol sequences corresponding to the interleave symbol sequences using an interleave matrix with I columns;
FEC-decoding means for carrying out a decoding on the output of the deinterleave means to obtain FEC-decoded symbol sequences containing m0 bits per symbol; and
data rate conversion means for converting the data rate of the symbol sequence output from the FEC-decoding means from m0 to n-out to output by a unit of n-out bits, wherein the values of I, m0 and n-out are so defined that the product of the I and m0 are divided by the n-out without a reminder.

54. A transmission system for interleaving FEC-encoded symbol sequences for transmission, comprising:
a transmitting section in which symbol sequences input in a unit of n-out bits are applied with the rate change from n-out to m0, the FEC-encoded symbol sequence thus obtained are composed to FEC-encoded symbol sequences for every unit of ns symbols, an interleave matrix of the number of rows I is formed by obliquely arranging every interleave blocks in an arbitrarily set arranging order, and the interleave symbol sequences are interleaved for transmission; and
a receiving section in which decoded symbol sequences containing m0 bits per symbol are obtained by carrying out a deinterleaving and a FEC-decoding on a received symbol sequence corresponding to the interleaved symbol sequence in opposite to those in the transmitting section, and the FEC-decoded symbol sequences are converted their data rate from m0 to n-out for outputting by unit of n-out bits wherein the values of I, m0 and n-out are so defined that the product of the I and m0 are divided by the n-out without a reminder.

55. An encoder for interleaving FEC-encoded symbol sequences for transmission, comprising:
data rate conversion means for converting the rate of symbol sequences input in a unit of n-out bits from n-out to m0;
FEC-encoding means for carrying out the FEC-encoding to the symbol sequences output from the data rate conversion means for every m0 bits; and
interleave means for constituting interleaved blocks obtained through the FEC-encoding by dividing the symbol sequence into every unit of ns symbols and then constituting an interleave matrix with I columns by carrying out an oblique arrangement through an arbitrarily converting the arrangement order for every interleave block for transmitting the interleaved symbol sequence;
wherein the values of I, m0 and n-out are so defined that the product of the I and m0 are divided by the n-out without a reminder.

56. A decoder for decoding an interleaved symbol sequence encoded by the encoder for transmission as defined by claim 55, comprising:
deinterleave means for carrying out a deinterleave opposite to those in the transmitting section on the received symbol sequences corresponding to the interleave symbol sequences using an interleave matrix with I columns in the converted order;
error rate detecting means for detecting an error rate of the symbol sequences obtained by the deinterleave means;
means for supplying the interleaved symbol sequences to the deinterleave means again by sequentially shifting the deinterleave timing by the deinterleave means when the detected error rate exceeds a specified value;
FEC-decoding means for carrying out a decoding on the output of the deinterleave means to obtain FEC-decoded symbol sequences containing m0 bits per symbol; and
data rate conversion means for converting the data rate of the symbol sequence output from the FEC-decoding means from m0 to n-out to output by a unit of n-out bits, wherein the values of I, m0 and n-out are so defined that the product of the I and m0 are divided by the n-out without a reminder.
